# EUROPÄISCHE PATENTSCHRIFT

(11) **EP 1 883 534 B1**
(45) Veröffentlichungstag und Bekanntmachung des Hinweises auf die Patenterteilung: **01.12.2010**
(21) Anmeldenummer: 06743062.9
(22) Anmeldetag: 24.05.2006
(51) Int. Cl.: B41C 1/10, B41N 3/00, G03F 7/004, G03F 7/075

(54) **REGENERIERBARE, STRUKTURIERTE PLATTE MIT OXIDATIONSKATALYSATOREN**
REGENERATABLE, STRUCTURED PLATE COMPRISING OXIDATION CATALYSTS
PLAQUE STRUCTUREE POUVANT ETRE REGENEREE, DOTEE DE CATALYSEURS D'OXYDATION

(30) Priorität: 24.05.2005 DE 102005023871
(43) Veröffentlichungstag der Anmeldung: 06.02.2008
(73) Patentinhaber: Leibniz-Institut für Neue Materialien gemeinnützige GmbH, 66123 Saarbrücken (DE)
(72) Erfinder: MENNIG, Martin, 66287 Quierschied (DE); OLIVEIRA, Peter, 66111 Saarbrücken (DE); SCHMIDT, Helmut, 66130 Saarbrücken-Güdingen (DE)
(74) Vertreter: Vièl, Christof
(86) Internationale Anmeldenummer: PCT/EP2006/004979
(87) Internationale Veröffentlichungsnummer: WO 2006/125635

(56) Entgegenhaltungen:
- EP-A- 1 346 847
- US-A1- 2002 017 776

## Beschreibung

Die vorliegende Erfindung betrifft Verfahren zur Herstellung von regenerierbaren Platten mit strukturierter Oberfläche aus hydrophilen und hydrophoben Bereichen, wobei die Schicht, die die hydrophilen Bereiche bildet, einen Oxidationskatalysator enthält, die daraus erhältlichen regenerierbaren Platten mit strukturierter Oberfläche, ein Verfahren zur Regenerierung dieser Platten, ein Flachdruckverfahren und weitere Verwendungen für diese regenerierbaren, strukturierten Platten.

Die Strukturierung von Oberflächen ist eine interessante Technik und es gibt verschiedene Verfahren, um dies zu erreichen. So können z.B. bei der Photolithographie aus lichtempfindlichen Materialien lösliche Bereiche herausgelöst werden, die z.B. durch Maskenbelichtung, Laserschreiben oder Zweiwellenmischen erzeugt werden, und somit Oberflächenstrukturen erzielt werden. Beim Offsetdruck wird über ein photolithographisches Verfahren die Polarität der Oberflächen verändert und dadurch werden benetzbare und nicht benetzbare Bereiche (hydrophile/hydrophobe Bereiche) erzeugt. Darüber hinaus können durch chemische Oberflächenmodifikation reaktive Gruppen an Oberflächen angebunden werden, die z.B. über Laserablation selektiv strukturiert werden können. Damit lassen sich funktionelle Oberflächenstrukturen erzeugen. Allen diesen Verfahren ist jedoch gemein, dass sie nicht rückgängig gemacht werden können, d.h. nicht reversibel sind.

Die Einstellung der Hydrophilie bzw. Hydrophobie von Oberflächen ist auch technisch bedeutsam, da neben dem Einsatz in Druckverfahren weitere Anwendungen bekannt sind, bei denen es erforderlich ist, nach Bedarf entweder eine Oberfläche hydrophil oder hydrophob zu gestalten, ohne dass größere Eingriffe dazu erforderlich sind. Schichten aus einem oxidischen Material zeigen häufig hydrophile Eigenschaften. Hingegen zeigen Oberflächen, die mit Siliconschichten hydrophobiert werden, ein ausgesprochen hydrophobes Verhalten und bilden Kontaktwinkel von über 100° gegen Wasser. Ebenso hydrophob werden Metall-, Glas- oder Keramikoberflächen, wenn sie mit dünnen Ölfilmen überzogen werden.

Oberflächenstrukturierte Systeme aus hydrophilen und hydrophoben Bereichen können wie gesagt z.B. für Druckvorgänge verwendet werden, bei denen ein Material bildmäßig auf ein Empfangsmedium übertragen wird. Damit können z.B. Bilder gedruckt, Informationen aufgezeichnet oder Strukturen, z.B. für Leiterplatten, aufgebaut werden. Die Herstellung der oberflächenstrukturierten Systeme ist kompliziert und kostspielig. In der Regel ist ein mehrstufiges Verfahren erforderlich, das komplexe chemische Reaktionsketten und/oder Ätzstufen beinhaltet. Dies bedeutet auch lange Herstellungszeiten und einen hohen Chemikalienbedarf mit der damit verbundenen Entsorgungsproblematik. Vor allem bei Mikro- und Nanostrukturen nehmen diese Schwierigkeiten wegen der erforderlichen Genauigkeit zu. Außerdem sind die einmal hergestellten Oberflächenstrukturen häufig nicht mehr veränderbar, so dass bei einer Beschädigung oder bei einer gewünschten Änderung des zu druckenden Bildes das ganze Substrat verworfen werden muss.

Die EP 1 346 847 A2 beschreibt ein Verfahren zum Regenerieren einer Druckplatte zur zukünftigen Wiederverwendung, umfassend eine lichtempfindliche Schicht, die auf der Oberfläche eines Trägers ausgebildet ist und einen Fotokatalysator aufweist, der auf aktivierendes Licht, das eine Energie aufweist, die höher ist als ein Abstand zwischen Energiebändern des Fotokatalysators, hydrophile Eigenschaften aufweist, und in einem oder mehreren hydrophoben Bildbereichen, die unter Verwendung einer organischen Zusammensetzung auf der Oberfläche der lichtempfindlichen Schicht ausgebildet werden, und die Funktion aufweisen, Tinte aufzunehmen, wobei das Verfahren nach dem Entfernen von Tinte, die auf der Oberfläche der Druckplatte verbleibt, ausgeführt wird, wobei das Verfahren die gesamte Fläche der Druckplatte durch die folgenden Schritte hydrophilisiert:
- Bestrahlen der Oberfläche einer Druckplatte, von der die Tinte entfernt wurde, mit aktivierendem Licht;
- Aufbringen von Wasser auf die Oberfläche der Druckplatte und .
- Bestrahlen der Oberfläche der Druckplatte mit dem aktivierenden Licht.

Aus der US 2002/0001776 A1 ist ein Verfahren zum Herstellen einer regenerierbaren Platte bekannt, wobei die strukturierte Oberfläche mit hydrophilen und hydrophoben Bereichen mit einer zusätzlichen hydrophoben Schicht ganzflächig beschichtet wird, so daß die regenerative Platte wieder für eine Strukturierung mit einem neuen Bildmuster zur Verfügung steht.

Die erfindungsgemäße Aufgabe bestand darin, ein Verfahren bereitzustellen, mit dem auf einfache, preiswerte und schnelle Weise eine Oberflächenstruktur aus hydrophoben und hydrophilen Bereichen hergestellt werden kann, die sich für den Druck von Materialien eignet und mit dem auch Strukturen im Mikrometerbereich genau dargestellt werden können. Insbesondere sollten die eingesetzten Platten regenerierbar sein, d.h. das Verfahren soll eine variable und reversible Gestaltung definierter Oberflächenstrukturen gestatten, damit die Platten wiederholt neu strukturiert können, so dass eine Wiederverwendung der Platten möglich ist.

Die erfindungsgemäße Aufgabe wurde überraschenderweise dadurch gelöst, dass ein oxidationskatalytisch wirksames Beschichtungssystem mit einem hydrophilen Oxidationskatalysator auf einer Oberfläche mit organischen Substanzen oder Substanzen, die organische hydrophobe Gruppen enthalten, hydrophobiert wird, so dass die Oberfläche mit Wasser, wässrigen Lösungen oder Suspensionen nicht mehr benetzt werden kann, und das erhaltene System dann selektiv belichtet wird, so dass die hydrophobe Schicht an der bestrahlten Stelle lokal erhitzt und durch den Oxidationskatalysator restlos oxidiert und damit entfernt wird. Die so bestrahlte Fläche wird wieder benetzbar, weil der darunter liegende hydrophile Oxidationskatalysator eine benetzbare Oberfläche besitzt.

Demgemäß wird erfindungsgemäß ein Verfahren zur Herstellung einer regenerierbaren Platte mit strukturierter Oberfläche aus hydrophilen und hydrophoben Bereichen bereitgestellt, bei dem man die Oberfläche einer regenerierbaren Platte, die ein Substrat und eine darüber liegende Schicht mit einer spezifischen Oberfläche der Schicht von 20 m²/g bis 250 m²/g, bestimmt nach dem BET-Verfahren mit Stickstoff, aus einer Masse, die einen hydrophilen Oxidationskatalysator enthält, umfasst, mit einer hydrophoben Schicht beschichtet und bildmäßig belichtet, wobei Katalysator und Schicht in den belichteten Bereichen durch die Belichtung erwärmt werden, so dass die hydrophobe Schicht in den belichteten Bereichen unter Freilegung des darunter liegenden hydrophilen Oxidationskatalysators oxidativ zersetzt wird.

Durch den Oxidationskatalysator wird es überraschenderweise möglich, eine bei Raumtemperatur stabile hydrophob Schicht durch bildmäßige Belichtung in den belichteten Bereichen auf genügend hohe Temperaturen zu erwärmen, um sie oxidativ zu zersetzen, während die nicht belichteten Bereiche ausreichend kühl bleiben, um nicht zersetzt zu werden. Erstaunlicherweise ist die Wärmeselektivität so hoch, dass damit sogar Strukturen im Nanometerbereich darstellbar sind.

Das erfindungsgemäße Verfahren zeichnet sich insbesondere durch die Regenerierbarkeit aus, d.h. die Platten mit strukturierter Oberfläche können erstaunlicherweise regeneriert werden, da eine Platte umfassend das Substrat und die Schicht aus einer Masse, die einen hydrophilen Oxidationskatalysator enthält, die mit einer hydrophoben Schicht strukturiert worden ist, sauber von der darauf befindlichen hydrophoben Bereichen befreit werden kann. Dies kann durch eine flächenmäßige Belichtung erfolgen, bei der die hydrophoben Bereiche thermokatalytisch oxidativ zerstört werden. Thermokatalytisch bedeutet dabei, dass die oxidative Zersetzung in der Wärme katalytisch erfolgt Durch diese oxidative Zersetzung verbleiben im Gegensatz zu einer einfachen thermischen Zersetzung, die zu Pyrolyserückständen führt, praktisch keine Reste oder Rückstände der hydrophoben Bestandteile auf der

Platte. Dadurch kann die Platte ohne Einschränkungen zur erneuten Strukturierung durch Hydrophobierung und bildmäßige Belichtung wiederverwendet werden.

Da die Platte oder der Zylinder mit der den hydrophilen Oxidationskatalysator enthaltenden Schicht gegenüber der hydrophoben Schicht natürlich einen ungleich größeren Materialwert besitzt, ist die Wiederwendbarkeit oder Regenerierbarkeit der Platte in wirtschaftlicher Hinsicht von besonderer Bedeutung.

Durch die bildmäßige Belichtung wird auf der Oberfläche ein entsprechendes Bild bzw. Muster aus den hydrophoben und hydrophilen Bereichen gebildet. Für den anschließenden Druck ist insbesondere das sich bildende zweidimensionale Muster auf der Oberfläche relevant.

Bei dem sich bildenden Muster kann es sich um jedes gewünschte Muster handeln. Es kann sich um regelmäßige oder unregelmäßige Muster handeln. Regelmäßige Formen sind z.B. Punkte, Linien oder Flächen wie Dreiecke, Rechtecke, Vielecke, Kreise oder Ellipsen. Es kann sich natürlich auch um gekrümmte Linien oder unregelmäßige Flächen handeln. Durch Kombination einzelner Formen kann das gewünschte Gesamtmuster gebildet werden, z.B. zur Wiedergabe von Zahlen, Buchstaben.. Bildern, Schaltkreisen, anderer Informationen oder zum Aufbau bestimmter Strukturen. Das zu druckende Muster kann dem hydrophilen Bereich oder dem hydrophoben Bereich entsprechen.

Die hydrophile Schicht und die hydrophobe Schicht befinden sich auf dem Substrat. Das Substrat kann jede geeignete Form aufweisen. Es liegt z.B. als ebenes oder zylinderförmiges Substrat vor, das sich z.B. als Druckplatte oder -walze eignet. In der Beschreibung und den Ansprüchen beinhaltet die Platte demgemäß auch einen Zylinder oder eine Walze. Ebene Substrate können z.B. auf einen Zylinder aufgespannt werden. Die erfindungsgemäße Platte kann dementsprechend ebenfalls jede geeignete zweckmäßige Form, z.B. eben oder zylinderförmig, annehmen. Bei dem Substrat kann es sich um jedes für den Zweck geeignete Material handeln. Beispiele für geeignete Materialien sind Metalle oder Metalllegierungen, Glas,

Keramik, einschließlich Oxidkeramik, Glaskeramik, Papier oder Kunststoff, einschließlich Gummi. Das Substrat kann auch in Form einer Folie vorliegen.

Selbstverständlich kann es sich auch um Substrate handeln, die mit einer Oberflächenschicht versehen sind, für die ebenfalls die vorstehend genannten Materialien verwendet werden können. Bei der Oberflächenschicht kann es sich z.B. um eine Metallisierung, eine Emaillierung, z.B. ein emailliertes Blech, eine Keramikschicht oder eine Lackierung handeln. Bei Keramikoberflächen kann es sich z.B. um dünne Überzüge von keramischen Komponenten auf Metallen handeln. Die Substrate können vorbehandelt sein. Beispielsweise können sie gereinigt werden, z.B. mit handelsüblichen alkalischen Reinigem, oder für eine Beschichtung vorbereitet werden, z.B. durch Coronabehandlung.

Beispiele für Metalle oder Metalllegierungen sind Stahl, einschließlich Edelstahl, Chrom, Kupfer, Titan, Zinn, Zink, Messing und Aluminium. Beispiele für Glas sind Natronkalkglas, Borosilicatglas, Bleikristall und Kieselglas. Es kann sich z.B. um Flachglas, Hohlglas wie Behälterglas, oder um Laborgeräteglas handeln. Bei der Keramik handelt es sich z.B. um eine Keramik auf Basis der Oxide Si02, Al₂03, Zr0₂ oder MgO oder der entsprechenden Mischoxide. Eine lackierte Oberfläche kann aus üblichen Grundanstrichen oder Lacken auf Basis organischer Bindemittel gebildet sein. Gegebenenfalls kann das Substrat selbst die hydrophile Schicht darstellen, so dass die hydrophobe Schicht direkt auf ein Substrat mit hydrophilen Oberflächeneigenschaften aufgebracht wird. Vorzugsweise befindet sich aber die hydrophile Schicht auf einem gesonderten Substrat.

Auf dem Substrat befindet sich eine Schicht mit dem hydrophilen Oxidationskatalysator und darauf wird eine hydrophobe Schicht aufgebracht. Das Konzept der Hydrophilie! Hydrophobie ist als Grundkonzept der Chemie dem Fachmann bestens bekannt. Hydrophobe Substanzen stoßen Wasser ab, während hydrophile Substanzen Wasser anziehen. Der hydrophile Charakter kann z.B. durch Hydroxy-, Oxy-, Carboxylat-, Sulfat-, Sulfonatfunktionen oder Polyetherketten in der Substanz gebildet werden. Ein hydrophober Charakter wird z.B. typischerweise durch Kohlenwasserstoffreste wie Alkylreste oder aromatische Reste in der Substanz erzeugt.

Der hydrophobe bzw. hydrophile Charakter der Schichten wird insbesondere durch die für die Schichten verwendeten Substanzen und gegebenenfalls deren Modifikation bestimmt. Dem Fachmann ist ohne weiteres ersichtlich, welche Materialien und Bearbeitungsmethoden er auszuwählen hat. Der hydrophobe/hydrophile Charakter einer Schicht kann z.B. durch den Kontaktwinkel gegen Wasser oder einem anderen geeigneten Lösungsmittel bestimmt werden.

Der Unterschied zwischen dem hydrophilen Charakter der einen Schicht und dem hydrophoben Charakter der anderen Schicht braucht nur so groß zu sein, dass eine ausreichende Selektivität des zu druckenden Materials für eine der beiden Schichten gewährleistet ist. Dem Fachmann sind die erforderlichen Einstellungen bekannt. Bevorzugt weist der hydrophile Bereich einen auf glatter Fläche gemessenen Kontaktwinkel gegen Wasser von ≤ 30° auf, während der hydrophobe Bereich einen auf glatter Fläche gemessenen Kontaktwinkel gegen Wasser von ≥ 85° aufweist.

Die untere Schicht besteht aus einer Masse, die einen hydrophilen Oxidationskatalysator enthält, wodurch zumindest an den Stellen, an der sich der Oxidationskatalysator befindet, eine hydrophile Schicht erhalten wird. Der Oxidationskatalysator umfasst eine katalytisch aktive Spezies und gegebenenfalls ein Trägermaterial. Die Masse kann neben dem Oxidationskatalysator ein Bindemittel enthalten, um die Haftung des Oxidationskatalysators auf dem Substrat zu gewährleisten oder zu verbessern.

Die untere Schicht enthält einen oder mehrere hydrophile Oxidationskatalysatoren, wobei es sich bevorzugt um Oxidkatalysatoren handelt. Oxidationskatalysatoren sind schon seit langen bekannt und der Fachmann kann ohne weiteres herkömmliche Oxidationskatalysatoren auswählen. Einen Übersichtsartikel findet man z.B. in Ullmanns Encyklopädie der technischen Chemie, 4. Auflage, Bd. 13, Seiten 517-570; Beispiele für Oxidationskatalysatoren sind in Tabelle 15F auf Seite 548 aufgeführt und die nachstehend diskutierten Oxidkatalysatoren werden allgemein auf Seite 530 und 531 behandelt. Bei dem Oxidationskatalysator handelt es sich insbesondere um einen anorganischen Oxidationskatalysator.

Die Oxidationskatalysatoren sind in der Lage, bei Wärmeaktivierung Oxidationsreaktionen zu katalysieren. Je nach gewählten Bedingungen und Materialien kann bei der Katalyse die Oxidation organischer Substanzen soweit fortschreiten, dass die organischen Substanzen sich unter Bildung flüchtiger oder verdampfbarer Bruchstücke (z.B. niedermolekularer Carbonsäuren, CO₂) zersetzen.

Der geeignete Temperaturbereich hängt naturgemäß von den vorliegenden Materialien (z.B. der hydrophoben Schicht), Katalysatoren und Zustandsformen ab, in der Regel werden die Komponenten so gewählt, dass die katalytische Zersetzungsreaktion bei Umgebungstemperatur nicht erfolgt, sondern erst bei Erwärmung, z.B. bei einer Temperatur von 40°C oder 60°C oder mehr für die Zersetzungsreaktion. Vorzugsweise liegt die Temperatur für die thermische Aktivierung der Zersetzungsreaktion im Bereich von 100°C bis 900°C, bevorzugt 100° bis 700°C, und besonders bevorzugt 200°C bis 500°C. Der Oxidationskatalysator kann in Abhängigkeit von den hydrophilen und hydrophoben Schichten in geeigneter Weise im Hinblick auf den gewünschten Temperaturbereich ausgewählt werden. Die Selektivität der oxidativen Zersetzungsreaktion wird durch den Temperaturunterschied zwischen belichteten und unbelichteten Bereichen erreicht.

Die thermokatalytisch wirkenden Oxidationskatalysatoren umfassen katalytisch aktive Spezies. Bei den katalytisch aktiven Spezies handelt es sich bevorzugt um Oxide, insbesondere Metalloxide und vor allem Übergangsmetalloxide. Unter den Übergangsmetallen werden wie üblich die Elemente der Nebengruppen I bis VIII des Periodensystems und die Lanthaniden- und Actiniden-Elemente verstanden. Der Oxidationskatalysator umfasst bevorzugt ein Oxid von mindestens einem Übergangsmetall ausgewählt aus La, Ce, Ti, Zr, V, Cr, Mo, W, Mn, Fe, Co, Ni, Cu, Nb, Ta, Ag und Zn.

Bevorzugt werden als Oxidationskatalysatoren Mehrkomponentensysteme verwendet, die aus einem Oxid von zwei oder mehr Übergangsmetallen bestehen. Die erhaltenen Strukturen können komplex sein und Metalloxidmischungen aus verschiedenen Metalloxiden oder Mischmetalloxide (ein Oxid mit mindestens zwei verschiedenen Metallen) oder Mischungen davon und Metalle in unterschiedlichen Oxidationsstufen umfassen. Die Strukturen sind manchmal gar nicht vollständig in allen Einzelheiten geklärt.

Neben den vorstehend genannten Übergangsmetallen kann der Oxidationskatalysator Zusatzelemente, wie Bi, Sn, P, Sb, Alkalimetalle oder Erdalkalimetalle, als Promotoren zur Steigerung der Aktivität enthalten. Diese Promotoren oder Co-Katalysatoren können z. B. in Mengen von 1 bis 5 Gew.-%, bezogen auf das eingesetzte Übergangsmetalloxid, eingesetzt werden. Geeignete Co-Katalysatoren sind etwa K-, Mg-, Ca-, Ba- und Sr-Salze sowie Al-, Si- und Sn-Oxide. Als Salze eignen sich beispielsweise die entsprechenden Halogenide, Hydroxide, Nitrate, Carbonate, Phosphate oder Carbonate. Je nach eingesetzten Bedingungen können die Anionen der eingesetzten Salze im Katalysator verbleiben, ausgewaschen werden oder umgewandelt werden. So können z.B. Nitrate bei einer Calcinierung als Stickstoffoxide gegebenenfalls unter Zurücklassung von Oxiden abgedampft werden.

In einer bevorzugten Ausführungsform enthalten die Oxidationskatalysatoren OxidKatalysatoren von mindestens zwei Übergangsmetallen und gegebenenfalls Promotoren. Ein bevorzugter Oxidkatalysator enthält z.B. Mn und Ce, gegebenenfalls mit weiteren Übergangsmetallen, wie Oxide von Mn/Co/Ce, Mn/Cu/Ce, Mn/Ni/Ce, Mn/Fe/Ce oder Mn/Co/Ni/Ce. Ein weiterer bevorzugter Oxidkatalysator umfasst ein Oxid von Cu/V/La. Besonders bevorzugt sind Oxidkatalysatoren, die Mangan und Kupfer enthalten, z.B. Mn/Cu/Ce, wobei Mn/Cu/K-Oxide mit Kalium als Promotor noch mehr bevorzugt sind. Auch die anderen Oxidkatalysatoren können selbstverständlich Promotoren enthalten.

In den Übergangsmetalloxiden können z.B. folgende Mengen der entsprechenden Metalloxide in der Metalloxidmischung bevorzugt sein: Ce: 1-70 Gew.%, V: 5-70 Gew.%, Mn: 20-95 Gew.%, Fe: 20-95 Gew.%, Co: 1-50 Gew.%, Ni: 1-50 Gew.% und/oder Cu: 1-95 Gew.%. Beispiele für einzelne Übergangsmetalloxide sind CuO, Cu₂O, V₂O₅, MnO₂ (Pyrolusit), γ-MnO₂, Co₃O₄, Co₂O₃, CoO und CeO₂.

Die Oxidationskatalysatoren umfassen in einer bevorzugten Ausführungsform auch ein Trägermaterial. Die Trägermaterialien sind in der Regel katalytisch inert und dienen z.B. zur Bildung einer großen Oberfläche. Solche Trägermaterialen sind dem Fachmann auf dem Gebiet der Katalysatoren bekannt und die herkömmlichen Trägermaterialien können verwendet werden. Beispiele für Trägermaterialien sind Aluminiumoxide, Siliciumoxide, insbesondere Silicagele, Aktivkohle, Siliciumcarbid, Titandioxid, Magnesiumoxid, verschiedene Silicate und Zeolithe. Besonders bevorzugt werden oxidische Trägermaterialien eingesetzt. Die Porosität und die spezifische Oberfläche der Träger können durch dem Fachmann bekannte Verfahren nach Bedarf eingestellt werden.

Die Herstellung der Oxidationskatalysatoren kann nach den herkömmlichen, dem Fachmann bekannten Verfahren erfolgen, wie z.B. in dem oben genannten Artikel aus Ullmanns Encyklopädie der technischen Chemie allgemein erläutert. Die Oxidationskatalysatoren können z.B. als Fällungskatalysatoren oder als Imprägnier- oder Tränkkatalysatoren gebildet werden und dann weiteren Behandlungsschritten wie Trocknen oder Calcinieren unterworfen werden. In der vorliegenden Erfindung werden bevorzugt Katalysatoren verwendet, die durch Imprägnierung von katalytisch aktiven Spezies oder deren Vorstufen auf Trägermaterialien und gegebenenfalls weiteren Behandlungsstufen erhalten werden.

Die Oxidationskatalysatoren sind hydrophil und können in der Regel z.B. in Form von Teilchen in der Schicht enthalten sein. Der Teilchendurchmesser der Oxidationskatalysator-Teilchen kann je nach Bedarf ausgewählt werden. In einer bevorzugten Ausführungsform handelt es sich bei dem Oxidationskatalysator um eine IR-absorbierende Substanz, um den Erwärmungseffekt durch Belichtung im IR-Wellenbereich zu verstärken.

Vorzugsweise sind 1 Gew.-% bis 100 Gew.-%, bevorzugter 5 Gew.-% bis 70 Gew.-% und insbesondere 10 Gew.-% bis 25 Gew.-% der fertigen Schicht hydrophiler Oxidationskatalysator.

Die untere Schicht kann nur aus dem Oxidationskatalysator bestehen, so dass die Beschichtungszusammensetzung zur Aufbringung dieser Schicht auf das Substrat nur aus dem Oxidationskatalysator und gegebenenfalls Lösungsmittel besteht. Die Beschichtungszusammensetzung für die Herstellung der unteren Schicht enthält neben dem hydrophilen Oxidationskatalysator aber bevorzugt auch ein Bindemittel, um die Haftung der Schicht an dem Substrat und/oder die Festigkeit der Schicht zu verbessern. Als Bindemittel können organische Polymere eingesetzt werden, gewöhnlich handelt es sich aber um anorganische und insbesondere um organisch modifizierte anorganische Polykondensate oder deren Vorstufen und/oder nanoskalige Teilchen. Die Zusammensetzung der vorteilhaften Polykondensate und nanoskaligen Teilchen wird im folgenden beschrieben. Das Bindemittel liegt vorzugsweise in Form eines Sols vor.

Bei dem anorganischen oder organisch modifizierten anorganischen Polykondensat handelt es sich insbesondere um ein Kondensat von Halbmetallen oder Metallen M, die auch als glas- oder keramikbildende Elemente bezeichnet werden, insbesondere aus den Hauptgruppen III bis V und/oder den Nebengruppen II bis V des Periodensystems der Elemente und Mg. Vorzugsweise handelt es sich um die Elemente Si, Al, B, Sn, Ti, Zr, Mg, V oder Zn, insbesondere solche von Si, Al, Ti, Zr und Mg oder Mischungen von zwei oder mehr dieser Elemente. Selbstverständlich können auch andere Halbmetalle oder Metalls M eingebaut werden, insbesondere solche der Hauptgruppen I und II des Periodensystems (z.B. Na, K und Ca) und der Nebengruppen VI bis VIII des Periodensystems (z.B. Mn, Cr, Fe und Ni). Es können auch Lanthanoiden verwendet werden. Bei den organisch modifizierten anorganischen Polykondensaten sind organische Seitengruppen im Kondensat enthalten.

Das Bindemittel wird bevorzugt aus hydrolysierbaren Verbindungen nach dem Sol-Gel-Verfahren erhalten. Beim Sol-Gel-Verfahren werden gewöhnlich hydrolysierbare Verbindungen mit Wasser, gegebenenfalls unter saurer oder basischer Katalyse, hydrolysiert und gegebenenfalls zumindest teilweise kondensiert. Die Hydrolyse- und/oder Kondensationsreaktionen führen zur Bildung von Verbindungen oder Kondensaten mit Hydroxy-, Oxogruppen und/oder Oxobrücken, die als Vorstufen dienen. Es können stöchiometrische Wassermengen, aber auch geringere oder größere Mengen verwendet werden. Das sich bildende Sol kann durch geeignete Parameter, z.B. Kondensationsgrad, Lösungsmittel oder pH-Wert, auf die für die Beschichtungszusammensetzung gewünschte Viskosität eingestellt werden. Weitere Einzelheiten des Sol-Gel-Verfahrens sind z.B. bei C.J. Brinker, G.W. Scherer: "Sol-Gel Science - The Physics and Chemistry of Sol-Gel-Processing", Academic Press, Boston, San Diego, New York, Sydney (1990) beschrieben.

Als Bindemittel werden bevorzugt nach dem Sol-Gel-Verfahren erhältliche organisch modifizierte anorganische Polykondensate oder dessen Vorstufen verwendet. Die organisch modifizierten anorganischen Polykondensate oder deren Vorstufen umfassen vorzugsweise Polyorganosiloxane oder deren Vorstufen. Die organischen Reste können gegebenenfalls funktionelle Gruppen enthalten, über die eine Vernetzung möglich ist. Beschichtungszusammensetzungen auf Basis organisch modifizierter anorganischer Polykondensate sind z.B. in DE 19613645, WO 92/21729 und WO 98/51747 beschrieben, auf die vollinhaltlich Bezug genommen wird.

Die organisch modifizierten anorganischen Polykondensate werden aus hydrolysierbaren Verbindungen gebildet, die neben hydrolysierbaren Gruppen auch mindestens eine nicht hydrolysierbare Gruppe aufweisen. Es können ausschließlich hydrolysierbare Verbindungen mit mindestens einer nicht hydrolysierbaren Gruppe zur Herstellung der Kondensate verwendet werden, gewöhnlich werden sie aber in Mischung mit hydrolysierbaren Verbindungen ohne nicht hydrolysierbare Gruppen eingesetzt.

Als hydrolysierbare Ausgangsverbindungen zur Herstellung der organisch modifizierten anorganischen Polykondensate können daher Verbindungen mit hydrolysierbaren Gruppen eingesetzt werden, wobei zumindest ein Teil, z.B. mindestens 10 Mol-%, dieser Verbindungen auch nicht hydrolysierbare Gruppen umfassen. Bevorzugt enthalten mindestens 50 Mol% und bevorzugter mindestens 60 Mol-% der eingesetzten hydrolysierbaren Ausgangsverbindungen mindestens eine. Nicht hydrolysierbare Gruppe. Das Stoffmengenverhältnis von hydrolysierbaren Verbindungen ohne nicht hydrolysierbare Gruppen zu hydrolysierbaren Verbindungen mit mindestens einer nicht hydrolysierbaren Gruppe beträgt z.B. 5-50:50-95 und bevorzugt 1:1 bis 1:6 und bevorzugter 1:3 bis 1:5, z.B. 1:4. Es können auch bereits teilweise umgesetzte Oligomere eingesetzt werden, die Mengenangaben beziehen sich aber immer auf monomere Ausgangsverbindungen.

Als hydrolysierbare Ausgangsverbindungen, die mindestens eine nicht hydrolysierbare Gruppe aufweisen, werden bevorzugt hydrolysierbare Organosilane oder Oligomere davon eingesetzt. Ein bevorzugtes Bindemittel basiert demnach bevorzugt auf einem z.B. nach dem Sol-Gel-Verfahren erhältlichen Polykondensat oder Vorstufen davon auf Basis von einem oder mehreren Silanen der allgemeinen Formel

RₐSiX₍₄₋ₐ₎ (I)

worin die Reste R gleich oder verschieden sind und nicht hydrolysierbare Gruppen darstellen, die Reste X gleich oder verschieden sind und hydrolysierbare Gruppen oder Hydroxygruppen bedeuten und a den Wert 1, 2 oder 3 hat, oder einem davon abgeleiteten Oligomer. Der Wert a ist bevorzugt 1 oder 2.

In der allgemeinen Formel (I) sind die hydrolysierbaren Gruppen X, die gleich oder voneinander verschieden sein können, beispielsweise Wasserstoff oder Halogen (F, Cl, Br oder I), Alkoxy (vorzugsweise C1-6-Alkoxy, wie z.B. Methoxy, Ethoxy, n-Propoxy, i-Propoxy und Butoxy), Aryloxy (vorzugsweise C6-10-Aryloxy, wie z.B. Phenoxy), Acyloxy (vorzugsweise C₁₋₆-Acyloxy, wie z.B. Acetoxy oder Propionyloxy), Alkylcarbonyl (vorzugsweise C₂₋₇-Alkylcarbonyl, wie z.B. Acetyl), Amino, Monoalkylamino oder Dialkylamino mit vorzugsweise 1 bis 12, insbesondere 1 bis 6 Kohlenstoffatomen. Bevorzugte hydrolysierbare Reste sind Halogen, Alkoxygruppen und Acyloxygruppen. Besonders bevorzugte hydrolysierbare Reste sind C₁₋₄-Alkoxygruppen, insbesondere Methoxy und Ethoxy.

Bei den nicht hydrolysierbaren Resten R, die gleich oder voneinander verschieden sein können, kann es sich um nicht hydrolysierbare Reste R mit einer funktionellen Gruppe, über die gegebenenfalls eine Vernetzung möglich ist, oder bevorzugt um nicht hydrolysierbare Reste R ohne eine solche funktionelle Gruppe handeln.

Der nicht hydrolysierbare Rest R ohne funktionelle Gruppe ist beispielsweise Alkyl (vorzugsweise C₁₋₈-Alkyl, wie Methyl, Ethyl, n-Propyl, Isopropyl, n-Butyl, sek.-Butyl und tert.-Butyl, Pentyl, Hexyl, Octyl oder Cyclohexyl), Alkenyl (vorzugsweise C₂₋₆-Alkenyl, wie z.B. Vinyl, 1-Propenyl, 2-Propenyl und Butenyl), Alkinyl (vorzugsweise C₂₋₆-Alkinyl, wie z.B. Acetylenyl und Propargyl), Aryl (vorzugsweise C₆₋₁₀-Aryl, wie z.B. Phenyl und Naphthyl) sowie davon abgeleitete Alkylaryle und Arylalkyle. Die Reste R und X können gegebenenfalls einen oder mehrere übliche Substituenten, wie z.B. Halogen oder Alkoxy, aufweisen.

Bevorzugte Beispiele sind Alkyltrialkoxysilane, wie Methyltri(m)ethoxysilan, Dialkyldialkoxysilane, Aryltrialkoxysilane, wie Phenyltri(m)ethoxysilan, und Diaryldialkoxysilane, wie Diphenyldi(m)ethoxysilan, wobei insbesondere Alkyl C₁₋₈-Alkyl und Alkoxy Methoxy oder Ethoxy ist. Bevorzugte Verbindungen sind Methyltriethoxysilan (MTEOS), Ethyltriethoxysilan, Phenyltriethoxysilan (PTEOS) oder Dimethyldiethoxysilan.

Der nicht hydrolysierbare Rest R mit einer funktionellen Gruppe, über die gegebenenfalls eine Vernetzung möglich ist, kann z.B. als funktionelle Gruppe eine Epoxid-(z.B. Glycidyl- oder Glycidyloxy-), Hydroxy-, Ether-, Amino-, Monoalkylamino-, Dialkylamino-, gegebenenfalls substituierte Anilino-, Amid-, Carboxy-, Acryl-, Acryloxy-, Methacryl-, Methacryloxy-, Mercapto-, Cyano-, Alkoxy-, Isocyanato-, Aldehyd-, Alkylcarbonyl-, Säureanhydrid- und Phosphorsäuregruppe umfassen, wobei Epoxid- und Aminogruppen bevorzugt sind. Diese funktionellen Gruppen sind über Alkylen-, Alkenylen- oder Arylen-Brückengruppen, die durch Sauerstoff- oder -NH-Gruppen unterbrochen sein können, an das Siliciumatom gebunden. Die Brückengruppen enthalten vorzugsweise 1 bis 18, vorzugsweise 1 bis 8 und insbesondere 1 bis 6 Kohlenstoffatome.

Die genannten zweiwertigen Brückengruppen und gegebenenfalls vorliegende Substituenten, wie bei den Alkylaminogruppen, leiten sich z.B. von den oben genannten einwertigen Alkyl-, Alkenyl- oder Arylresten ab. Natürlich kann der Rest R auch mehr als eine funktionelle Gruppe aufweisen.

Beispiel für Silane mit funktionellen Gruppen sind γ-Glycidyloxypropyltrimethoxysilan (GPTS), γ-Glycidyloxypropyltriethoxysilan (GPTES), 3-Isocyanatopropyltriethoxysilan, 3-Isocyanatopropyldimethylchlorsilan, 3-Aminopropyltrimethoxysilan (APTS), 3-Aminopropyltriethoxysilan, 3-(Aminoethylamin)propyltriethoxysilan, N-[N'-(2'-Aminoethyl)-2-aminoethyl]-3-aminopropyltrimethoxysilan, Hydroxymethyltriethoxysilan, Bis-(hydroxyethyl)-3-aminopropyltriethoxysilan, N-Hydroxyethyl-N-methylaminopropyltriethoxysilan, 3-(Meth)acryloxypropyltriethoxysilan und 3-(Meth)acryloxypropyltrimethoxysilan. Weitere Beispiele für erfindungsgemäß einsetzbare hydrolysierbare Silane können z.B. auch der EP-A-195493 entnommen werden.

Als zusätzliche Verbindungen ohne nicht hydrolysierbare Gruppen eignen sich insbesondere hydrolysierbare Silane der Formel

SiX₄ (II)

wobei X wie in Formel (I) definiert ist. Beispiele für hydrolysierbare Silane, die zur Herstellung des Bindemittels verwendet werden können, sind Si(OCH₃)₄, Si(OC₂H₅)₄, Si(O-n- oder -i-C₃H₇)₄, Si(OC₄H₉)₄, SiCl₄, HSiCl₃, Si(OOCCH₃)₄. Von diesen Silanen sind Tetraalkoxysilane und insbesondere Tetramethoxysilan und Tetraethoxysilan (TEOS) bevorzugt.

Das organisch modifizierte anorganische Polykondensat wird vorzugsweise aus einem Tetraalkoxysilan und mindestens einem Silan ausgewählt aus Alkyltrialkoxysilanen, Dialkyldialkoxysilanen, Aryltrialkoxysilanen und Diaryldialkoxysilanen gebildet, wobei Mischungen von Methyltriethoxysilan (MTEOS) und TEOS besonders bevorzugt sind. Das organisch modifizierte anorganische Polykondensat kann z.B. auch aus reinem MTEOS gebildet werden.

Weitere hydrolysierbare Verbindungen ohne nicht hydrolysierbare Gruppen, die neben den oder anstelle der Siliciumverbindungen der Formel (II) verwendet werden können, weisen insbesondere die allgemeine Formel MX_{b} auf, worin M das vorstehend definierte glas- oder keramikbildende Element M außer Si ist, X eine hydrolysierbare Gruppe oder Hydroxy ist, wobei zwei Gruppen X durch eine Oxogruppe ersetzt sein können, und b der Wertigkeit des Elements entspricht und meist 3 oder 4 ist. Beispiele für die hydrolysierbaren Gruppen X, die gleich oder voneinander verschieden sein können, sind Wasserstoff, Halogen (F, Cl, Br oder I, insbesondere Cl oder Br), Alkoxy (z.B. C₁₋₆-Alkoxy, wie z.B. Methoxy, Ethoxy, n-Propoxy, i-Propoxy und n-, i-, sek.- oder tert.-Butoxy), Aryloxy (vorzugsweise C₆₋₁₀-Aryloxy, wie z.B. Phenoxy), Alkaryloxy, z.B. Benzoyloxy, Acyloxy (z.B. C₁₋₆-Acyloxy, vorzugsweise C₁₋₄-Acyloxy, wie z.B. Acetoxy oder Propionyloxy), Amino und Alkylcarbonyl (z.B. C₂₋₇-Alkylcarbonyl wie Acetyl). Zwei oder drei Gruppen X können auch miteinander verbunden sein, z.B. bei Si-Polyolkomplexen mit Glycol, Glycerin oder Brenzcatechin. Die genannten Gruppen können gegebenenfalls Substituenten, wie Halogen oder Alkoxy, enthalten. Bevorzugte hydrolysierbare Reste X sind Halogen, Alkoxygruppen und Acyloxygruppen.

Bei den einsetzbaren Titanverbindungen handelt es sich insbesondere um hydrolysierbare Verbindungen der Formel TiX₄. Konkrete und bevorzugt eingesetzte Titanate zur Herstellung einer Beschichtungszusammensetzung nach dem Sol-Gel-Verfahren sind TiCl₄, Ti(OCH₃)₄, Ti(OC₂H₅)₄, Ti(2-ethylhexoxy)₄, Ti(n-OC₃H₇)₄ oder Ti(i-OC₃H₇)₄ Weitere Beispiele für einsetzbare hydrolysierbare Verbindungen von Elementen M sind Al(OCH₃)₃, Al(OC₂H₅)₃, Al(O-n-C₃H₇)₃, Al(O-i-C₃H₇)₃, Al(O-n-C₄H₉)₃, Al(O-sek.-C₄H₉)₃, AlCl₃, AlCl(OH)₂, Al(OC₂H₄OC₄H₉)₃, ZrCl₄, Zr(OC₂H₅)₄, Zr(O-n-C₃H₇)₄, Zr(O-i-C₃H₇)₄, Zr(OC₄H₉)₄, ZrOCl₂, Zr(2-ethylhexoxy)₄, sowie Zr-Verbindungen, die komplexierende Reste aufweisen, wie z.B. β-Diketon- und (Meth)acrylreste, Natriummethylat, Kaliumacetat, Borsäure, BCl₃, B(OCH₃)₃, B(OC₂H₅)₃, SnCl₄, Sn(OCH₃)₄, Sn(OC₂H₅)₄, VOCl₃ und VO(OCH₃)₃.

Rein anorganische Polykondensate oder Vorstufen als Bindemittel können in analoger Weise aus einer oder mehreren hydrolysierbaren Verbindungen der Formel (II) oder der Formel MX_{b}, wie vorstehend definiert, gebildet werden.

Als Bindemittel können auch nanoskalige Teilchen allein oder zusätzlich zu den genannten Polykondensaten (auch als Kondensate bezeichnet) verwendet werden. Die nanoskaligen Teilchen können die gleiche Zusammensetzung wie die vorstehend beschriebenen Polykondensate aufweisen. Beim Sol-Gel-Verfahren kann z.B. das Produkt manchmal je nach gewählten Bedingungen als Polykondensat oder in Form von nanoskaligen Teilchen erhalten werden. Weitere Beispiele für nanoskalige Teilchen werden nachstehend beschrieben.

Die nanoskaligen Feststoffteilchen, im folgenden auch als Nanopartikel bezeichnet, können organische Nanopartikel, z.B. aus einem Kunststoff, oder bevorzugt anorganische Nanopartikel sein. Bevorzugt handelt es sich um Nanopartikel aus Metall, einschließlich Metalllegierungen, Metallverbindungen, insbesondere Metallchalkogeniden, besonders bevorzugt die Oxide und Sulfide, wobei Metalle hier auch B, Si und Ge einschließen. Es kann eine Art von Nanopartikel oder eine Mischung von Nanopartikeln eingesetzt werden. Das Bindemittel kann vorteilhaft eine Kombination von nanoskaligen Teilchen und organisch modifizierten anorganischen Polykondensaten sein.

Weitere Nanopartikel können aus beliebigen Metallverbindungen sein. Beispiele sind (gegebenenfalls hydratisierte) Oxide wie ZnO, CdO, SiO₂, GeO₂, TiO₂, ZrO₂, CeO₂, SnO₂, Al₂O₃ (insbesondere Böhmit, AIO(OH), auch als Aluminiumhydroxid), B₂O₃, In₂O₃, La₂O₃, Fe₂O₃, Fe₃O₄, Cu₂O, Ta₂O₅, Nb₂O₅, V₂O₅, MoO₃ oder WO₃; weitere Chalkogenide, wie z.B. Sulfide (z.B. CdS, ZnS, PbS und Ag₂S), Selenide (z.B. GaSe, CdSe und ZnSe) und Telluride (z.B. ZnTe oder CdTe); Halogenide, wie AgCl, AgBr, Agl, CuCl, CuBr, CdI₂ und PbI₂; Carbide wie CdC₂ oder SiC; Arseniden wie AlAs, GaAs und GeAs; Antimonide wie InSb; Nitride wie BN, AIN, Si₃N₄ und Ti₃N₄; Phosphide wie GaP, InP, Zn₃P₂ und Cd₃P₂; Phosphate, Silikate, Zirkonate, Aluminate, Stannate und die entsprechenden Mischoxide (Leuchtpigmente mit Y- oder Eu-haltigen Verbindungen, Spinelle, Ferrite oder Mischoxide mit Perowskitstruktur wie BaTiO₃ und PbTiO₃).

Bei den nanoskaligen anorganischen Feststoffteilchen handelt es sich bevorzugt um ein Oxid oder Oxidhydrat von Si, Ge, Al, B, Zn, Cd, Ti, Zr, Ce, Sn, In, La, Fe, Cu, Ta, Nb, V, Mo oder W, besonders bevorzugt von Si, Al, B, Ti und Zr. Besonders bevorzugt werden Oxide bzw. Oxidhydrate eingesetzt. Bevorzugte nanoskalige anorganische Feststoffteilchen sind SiO₂, Al₂O₃, ITO, ATO, AIOOH, Ta₂O₅, ZrO₂ und TiO₂, wobei SiO₂ besonders bevorzugt ist.

Die Herstellung dieser nanoskaligen Teilchen kann auf übliche Weise erfolgen, z.B. durch Flammpyrolyse, Plasmaverfahren, Kolloidtechniken, Sol-Gel-Prozesse, kontrollierte Keim- und Wachstumsprozesse, MOCVD-Verfahren und Emulsionsverfahren. Diese Verfahren sind in der Literatur ausführlich beschrieben. Das Sol-Gel-Verfahren wurde vorstehend erläutert.

Die Partikel können in Form eines Pulvers oder direkt als Dispersion in einem Dispergiermittel verwendet werden. Beispiele für im Handel erhältliche Dispersionen sind die wässrigen Kieselsole der Bayer AG (Levasile^{®}) sowie kolloidale Organosole von Nissan Chemicals (IPA-ST, MA-ST, MEK-ST, MIBK-ST). Als Pulver sind z.B. pyrogene Kieselsäuren von Degussa (Aerosil-Produkte) erhältlich.

Nanoskalige Teilchen besitzen einen mittleren Teilchendurchmesser (Volumenmittel, Messung: wenn möglich röntgenographisch, sonst dynamische Laserlichtstreuung (mit einem Ultrafein-Partikelanalysator (UPA)) unter 1 µm, in der Regel unter 500 nm. Die nanoskaligen Feststoffteilchen besitzen bevorzugt einen mittleren Teilchendurchmesser von nicht mehr als 300 nm, bevorzugt nicht mehr als 200 nm und insbesondere nicht mehr 50 nm und mehr als 1 nm und vorzugsweise mehr als 2 nm, z.B. 1 bis 20 nm. Dieses Material kann in Form eines Pulvers eingesetzt werden, es wird jedoch vorzugsweise in Form eines Sols oder einer Suspension verwendet.

Die Nanopartikel können auch oberflächenmodifiziert sein. Bei der Oberflächenmodifizierung von nanoskaligen Teilchen handelt es sich um ein bekanntes Verfahren, wie es von der Anmelderin z.B. in WO 93/21127 (DE 4212633) oder WO 96/31572 beschrieben wurde. Die Herstellung der oberflächenmodifizierten Teilchen kann prinzipiell auf zwei verschiedenen Wegen durchgeführt werden, nämlich zum einen durch Oberflächenmodifizierung von bereits hergestellten nanoskaligen Teilchen und zum anderen durch Herstellung dieser Teilchen unter Verwendung von Oberflächenmodifizierungsmitteln.

Als Oberflächenmodifizierungsmittel eignen sich Verbindungen, die zum einen über eine oder mehrere Gruppen verfügen, die mit auf der Oberfläche der Nanopartikel vorhandenen reaktionsfähigen Gruppen (wie beispielsweise OH-Gruppen) reagieren oder wechselwirken können. Die Oberflächenmodifizierungsmittel können z.B. kovalente, koordinative (Komplexbildung) und ionische (salzartige) Bindungen zur Oberfläche der Nanopartikel ausbilden, während unter den reinen Wechselwirkungen beispielhaft Dipol-Dipol-Wechselwirkungen, Wasserstoffbrückenbindungen und van der Waals-Wechselwirkungen zu nennen sind. Bevorzugt ist die Ausbildung von kovalenten Bindungen.

Für die Oberflächenmodifikation der Nanopartikel kommen anorganische und organische Säuren, Basen, Chelatbildner, Komplexbildner, wie β-Diketone, Proteine, die komplexbildende Strukturen aufweisen können, Aminosäuren oder auch Silane in Frage. Konkrete Beispiele für Oberflächenmodifizierungsmittel sind gesättigte oder ungesättigte Mono- und Polycarbonsäuren, die entsprechenden Säureanhydride, Säurechloride, Ester und Säureamide, Aminosäuren, Proteine, Imine, Nitrile, Isonitrile, Epoxyverbindungen, Mono- und Polyamine, β-Dicarbonylverbindungen, wie β-Diketone, Oxime, Alkohole, Alkylhalogenide, Metallverbindungen, die über eine funktionelle Gruppe verfügen, die mit den Oberflächengruppen der Partikel reagieren kann, z.B. Silane mit hydrolysierbaren Gruppen mit mindestens einer nicht hydrolysierbaren Gruppe, die vorstehend beschrieben wurden. Weitere spezielle Verbindungen für Oberflächenmodifizierungsmittel sind z.B. in den oben genannten WO 93/21127 und WO 96/31572 genannt.

Die Nanopartikel können auch mit mindestens einem anderen Metall oder Halbmetall dotiert sein. Der Einsatz von Nanopartikeln in dem Bindemittel ist eine bevorzugte Ausführungsform, wobei die vorstehend beschriebenen Polykondensate bevorzugt in Anwesenheit der Nanopartikel hergestellt werden, wodurch ein stärkere Bindung zwischen Bindemittel und Polykondensat erreicht wird. Durch die Nanopartikel werden die Schichten härter und kratzfester. Die Nanopartikel können auch gesondert zur Beschichtungszusammensetzung gegeben werden. Die Verwendung der Nanopartikel als alleiniges Bindemittel ist wie gesagt möglich.

Als einsetzbare Lösungsmittel für die Beschichtungszusammensetzung kommen sowohl Wasser als auch organische Lösungsmittel oder Mischungen in Betracht. Dabei handelt es sich um die üblichen, auf dem Gebiet der Beschichtung eingesetzten Lösungsmittel. Beispiele für geeignete organische Lösungsmittel sind Alkohole, vorzugsweise niedere aliphatische Alkohole (C₁-C₈-Alkohole), wie Methanol, Ethanol, 1-Propanol, i-Propanol und 1-Butanol, Ketone, vorzugsweise niedere Dialkylketone, wie Aceton und Methylisobutylketon, Ether, vorzugsweise niedere Dialkylether, wie Diethylether, oder Diolmonoether, Amide, wie Dimethylformamid, Tetrahydrofuran, Dioxan, Sulfoxide, Sulfone oder Butylglycol und deren Gemische. Bevorzugt werden Alkohole verwendet. Es können auch hochsiedende Lösungsmittel verwendet werden. Beim Sol-Gel-Verfahren kann das Lösungsmittel gegebenenfalls ein bei der Hydrolyse gebildeter Alkohol aus den Alkoholatverbindungen sein.

Die Komponenten der Beschichtungszusammensetzung für die den Oxidationskatalysator enthaltende Schicht können in beliebiger Reihenfolge zusammengegeben werden. Z.B. kann zu dem nach dem Sol-Gel-Verfahren hergestellten Bindemittelsol der Oxidationskatalysator in Form eines Pulvers, Sols oder als Suspension zugegeben werden. Neben den genannten Komponenten können gegebenenfalls nach Bedarf weitere, dem Fachmann auf dem Gebiet der Beschichtungen bekannte Additive zugegeben werden. Die Zusammensetzung ist bevorzugt eine Dispersion, die Oxidationskatalysator-Teilchen und ein Bindemittel-Sol umfasst.

Für die Beschichtung des Substrats mit der Beschichtungszusammensetzung können die üblichen Beschichtungsverfahren Verwendung finden, z.B. Tauchen, Rollen, Rakeln, Fluten, Ziehen, Spritzen, Schleudern oder Aufstreichen. Ein zweckmäßiges Auftragverfahren ist der Auftrag mit einer Offsetwalze. Die aufgebrachte Beschichtungszusammensetzung wird gegebenenfalls getrocknet und gehärtet oder verdichtet.

Insbesondere bei vernetzbaren Bindemitteln kommt eine thermische oder photochemische Härtung der Schicht in Betracht. Bei der photochemischen Härtung ist Bestrahlung mit UV-Licht zweckmäßig. Ohne vernetzbare Gruppe wird die hydrophile Schicht durch Wärmebehandlung verdichtet oder eingebrannt. Die Temperatur und Dauer für Härtung oder Verdichtung bzw. Einbrennen hängen naturgemäß von den verwendeten Materialien ab. Im allgemeinen sind Temperaturen zwischen 90 und 600°C für eine Verdichtung zweckmäßig.

Die Bindemittel, falls eingesetzt, dienen der Verbesserung der Haftung, wobei die Mengenverhältnisse und die Bedingungen in herkömmlicher und bekannter Weise so gewählt werden, das hydrophile Oxidationskatalysatoren sich an der Oberfläche der fertiggestellten Schicht befinden, d.h. zumindest ein Teil der Oxidationskatalysatoren ist nicht vollständig von Bindemittel umgeben. Sofern ein organisch modifiziertes anorganisches Polykondensat und/oder entsprechende nanoskalige Teilchen als Bindemittel eingesetzt werden, besteht die Möglichkeit, dass die organischen Komponenten des Bindemittels im Verlauf der Beschichtungsprozedur (z.B. beim Einbrennen) und/oder bei der späteren Verwendung im erfindungsgemäßen Verfahren teilweise oder vollständig zersetzt werden, so dass die zurückbleibende Bindemittelkomponente nur anorganische Bestandteile aufweisen könnte.

Die erhaltene Schicht kann eine gewisse Porosität aufweisen, da damit in der Regel eine Verbesserung der katalytischen Aktivität verbunden ist. Allerdings sind in Abhängigkeit von der Wellenlänge der Belichtung Streueffekte zu beachten. Die Beschichtung ist daher zweckmäßigerweise eine poröse Schicht. Eine geeignete Porosität der Schicht kann z.B. mit einer spezifischen Oberfläche der Schicht, bestimmt nach dem BET-Verfahren mit Stickstoff, von 20 m²/g bis 250 m²/g, vorzugsweise von 30 m²/g bis 150 m²/g und insbesondere von 40 m²/g bis 80 m²/g angegeben werden.

Die den hydrophilen Oxidationskatalysator enthaltende Schicht weist zweckmäßigerweise eine Trockenschichtdicke von 1 bis 100 µm, vorzugsweise 2 bis 20 µm und insbesondere 3 bis 10 µm auf. Demgegenüber ist die darauf aufgebrachte hydrophobe Schicht bevorzugt ausgesprochen dünn. In diesem Sinne kann man sie auch als Film bezeichnen. Die hydrophobe Schicht weist vorzugsweise eine Schichtdicke von nicht mehr als 100 nm auf, z.B. im Bereich von 50 bis 100 nm. Noch bevorzugter handelt es sich bei der hydrophoben Schicht um sehr dünne Schichten oder sogar um einen molekularen Film, d.h um eine oder wenige "Lagen" der die hydrophobe Schicht bildenden Substanzen auf der Oberfläche der hydrophilen Schicht, z.B. mono-, di- oder trimolekulare Schichten. Die Hydrophobierung ist daher volumenmäßig unkritisch.

Die hydrophobe Schicht wird insbesondere durch Hydrophobisierung der den hydrophilen Oxidationskatalysator enthaltenden Schicht hergestellt. Hierfür wird vorzugsweise ein Hydrophobiermittel in üblicher Weise aufgebracht. Für das Hydrophobiermittel können alle herkömmlichen, in der Technik bekannten hydrophobisierenden Substanzen herangezogen werden. Dies können z.B. Kohlenwasserstoffe, organische Verbindungen mit langen Alkylketten oder deren Salze, organische Polymere oder deren Mischungen sein. Das Hydrophobiermittel soll möglichst keine anorganischen Reste enthalten. Es handelt sich daher bevorzugt um rein organische Substanzen. Die hydrophobisierende Substanz kann in reiner Form oder bevorzugt in einem Lösungsmittel für den Auftrag verwendet werden. Es können eine oder mehrere hydrophobisierende Substanzen verwendet werden. Die hydrophobe Schicht ist somit insbesondere frei von anorganischen Verbindungen oder Resten, um eine vollständige Oxidierbarkeit und Entfernbarkeit zu gewährleisten.

Beispiele für hydrophobisierende Substanzen für die hydrophobe Schicht im Hydrophobiermittel sind Paraffine, Wachse, Fette und Öle, längerkettige Kohlenwasserstoffe, Fettsäuren, Ölsäuren und Seifen. Beispiele für Wachse sind natürliche Wachse, wie Candelillawachs und Carnaubawachs, synthetisch modifizierte Wachse, wie Montanesterwachse, oder synthetische Wachse, wie Polyalkylenwachse. Beispiele für eine Fettsäure sind Ölsäure, Palmitinsäure und insbesondere Stearinsäure.

Als Lösungsmittel können Wasser und/oder organische Lösungsmittel, wie z.B. Kohlenwasserstoffe, chlorierte Kohlenwasserstoffe, Ether, Ester, höhere Akohole ab Butanol oder die oben genannten Lösungsmittel, verwendet werden. Die hydrophobisierende Substanz bildet in dem Lösungsmittel vorzugsweise eine Lösung oder eine Emulsion/Dispersion, z.B. wässrige Emulsionen. Das Hydrophobiermittel kann neben der hydrophobierenden Substanz und dem Lösungsmittel ferner gegebenenfalls metallische Katalysatoren, Emulgiermittel und/oder Polymere aller Art als Flexibilisatoren enthalten.

Das Hydrophobiermittel wird in herkömmlicher Weise auf die hydrophile Schicht aufgebracht. Jedes geeignete Auftragverfahren kann verwendet werden, z.B. Reiben oder die oben genannten Beschichtungsverfahren. Danach erfolgt in der Regel nur eine Trocknung zum Abdampfen des Lösungsmittels. Die Schichtdicke kann z.B. durch die Verdünnung im Lösungsmittel gesteuert werden. Gegebenenfalls kann auch eine Wärmebehandlung zur stärkeren Bindung an die hydrophile Schicht erfolgen. In der Regel ist es aber zweckmäßig, dass die hydrophobisierenden Substanzen keine kovalente Bindung mit den Oberflächengruppen der hydrophilen Schicht eingehen, allerdings ergeben solche Bindungen keine wesentliche Beeinträchtigung.

Das so erhaltene Substrat wird bildmäßig belichtet. Die Strukturierung kann z.B. durch eine Maskentechnik, über holographische Techniken, z.B. Zweiwellenmischen, die Nahfeldoptik (z.B. Nanolithographie) und durch Laserschreibverfahren erfolgen. Zur Belichtung können z.B. IR-Licht, UV-Licht oder Licht im sichtbaren Bereich verwendet werden, wobei der Einsatz von Laserlicht bevorzugt ist. Bei Verwendung von Laserlicht können kommerziell erhältliche Systeme (z.B. Lasergravurgeräte) verwendet werden. Die Schreibgeschwindigkeit oder die Belichtungsdauer wird der hydrophoben Schichtdicke angepasst und kann im Bereich von weniger als 1 s bis zu längeren Belichtungszeiten liegen.

Ein geeigneter Laser ist der CO₂-Laser, der im Infrarotbereich arbeitet. In jüngerer Zeit ist es gelungen, mit CO₂-Lasern eine Schreibbreite von bis zu 10 µm zu erzielen. So lassen sich beliebige Muster auf einer solchen Oberfläche schreiben. Durch Belichtung mit einem CO₂-Laser können die belichteten Stellen auf relativ einfache Weise auf die gewünschte Temperatur erwärmt werden. So können z.B. mit einem CO₂-Laser lokal Erwärmungen auf etwa 300°C erreicht werden, die an belichteten Stellen mit dem Sauerstoff der Luft zur Oxidation und Zersetzung der hydrophoben Schicht führen.

Die Benutzung eines UV-Lasers ist demgegenüber häufig relativ ungeeignet, wenn eine relativ hohe Erwärmung, z.B. über 300°C, erforderlich ist, da die Energiekopplung sehr gering ist und eine für die Zersetzung ausreichende Aufwärmung der belichteten Oberfläche häufig kaum erreichbar ist. Wird dem Hydrophobiermittel jedoch eine im UV absorbierende Substanz beigemischt, so erhöht sich die Absorption des UV-Laserstrahls beträchtlich und die UV-Strahlung wird durch Relaxationsprozesse in Wärme umgewandelt. Die UV-Absorptionsmittel eigenen sich auch bei Bestrahlung mit Licht im sichtbaren Bereich (VIS), UV-Licht ist aber bevorzugt. Mit solchen Additiven lassen sich effiziente Temperaturerhöhungen und damit ebenfalls thermisch aktivierte Oxidationskatalysen durchführen, so dass über eine solche Maßnahme auch UV-Laser in zweckmäßiger Weise zum Schreiben verwendet werden können. Der Vorteil dieser UV-Laser ist, dass das Auflösungsvermögen deutlich besser ist als die von CO₂-Lasern, so dass mit noch feineren Linien beschrieben werden kann (bis herab zu ca. 1 µm).

Ein vorteilhaftes Belichtungsverfahren ist auch die Nahfeldoptik, die z.B. für die Nanolithographie eingesetzt werden kann. Besonders vorteilhaft kann bei Anwesenheit von UV-Absorptionsmittel in der hydrophoben Schicht mit nahfeldoptischen Methoden im Bereich von UV- und/oder VIS-Licht gearbeitet werden.

In einer bevorzugten Ausführungsform für die Verwendung von UV-Licht und/oder VIS enthält die hydrophobe Schicht daher ein UV-Absorptionsmittel, bevorzugt ein organisches UV-Absorptionsmittel. Beispiele für UV-Absorptionsmittel sind dem Fachmann ohne weiteres geläufig und er kann je nach Fall ein geeignetes auswählen. Bevorzugte Beispiele sind Derivate des Benzophenons, wobei die Substituenten (z.B. Hydroxy- und/oder Alkoxygruppen) sich bevorzugt in 2- und/oder 4-Stellung befinden; substituierte Benzotriazole, in 3-Stellung Phenyl-substituierte Acrylate (Zimtsäure-Derivate) und Salicylate. Weitere bevorzugte UV-Absorber sind Naturstoffe wie 3-(5-Imidazolyl)acrylsäure (Urocansäure) und Ergosterol. Die Konzentration von UV-Absorber in der fertigen hydrophoben Schicht beträgt, falls verwendet, bevorzugt 0,1 bis 10 Gew.-%, insbesondere 2 bis 8 Gew.-% und bevorzugter 3 bis 5 Gew.-%.

Die Auflösungsbreite für die Strukturierung ist ausschließlich durch die Wellenlänge der Belichtung, insbesondere die Breite des Laserstrahls bedingt. Prinzipiell lassen sich auch sehr niedrige Auflösungen durch die Belichtung über nahfeldoptische Methoden im UV/VIS-Bereich erzielen (bis in den nm-Bereich). Es können daher erfindungsgemäß Strukturierungen im Mikro- und/oder im Nanometerbereich gebildet werden. Die mit UV-Belichtung erreichbaren Strukturierungen im µm-Bereich reichen z.B. für die bei Büchern geforderte Druckqualität aus.

Durch die Belichtung der Oberfläche erfolgt eine Zersetzung der hydrophoben Schicht in den bildmäßig belichteten Bereichen durch die gebildete Wärme in Kombination mit der Wirkung des Oxidationskatalysators, wobei in diesen Bereichen der darunter liegende hydrophile Oxidationskatalysator freigelegt wird. Auf diese Weise wird die gewünschte Struktur auf der Oberfläche gebildet.

Bei der Struktur handelt es sich bevorzugt um eine Mikrostruktur, d.h. zumindest in einigen Bereichen werden Strukturen mit Feinheiten im Mikrometerbereich gebildet. Ohne sich an eine Theorie binden zu wollen, wird davon ausgegangen, dass bei der Zersetzung der hydrophoben Schicht die darin befindlichen hydrophobisierenden Substanzen oxidiert und damit zersetzt und abgedampft werden. Vorzugsweise findet eine rückstandsfreie Zersetzung statt.

Die so erhaltenen Platten mit strukturierter Oberfläche eignen sich hervorragend zum Drucken einer Struktur auf ein Empfangsmedium. Hierbei wird ein Druckmaterial, dass hydrophob oder hydrophil ist, auf das Substrat aufgebracht, wobei sich das Material aufgrund des hydrophilen/hydrophoben Charakters nur auf den hydrophilen/hydrophoben Bereichen der strukturierten Oberfläche des Substrats abscheidet. Natürlich verteilt sich ein hydrophiles Material auf die hydrophilen Bereiche der Oberfläche und ein hydrophobes Material auf die hydrophoben Bereiche. Anschließend wird das mit dem Material beladene Substrat mit einem Empfangsmedium in Kontakt gebracht, wobei zweckmäßigerweise Druck angewendet wird, und dann werden Substrat und Empfangsmedium unter bildmäßiger Übertragung des Materials auf das Empfangsmedium voneinander getrennt.

Das Druckverfahren kann, abgesehen vom erfindungsgemäßen Substrat, wie bei einem herkömmlichen Flachdruckverfahren durchgeführt werden. Beispiele für Flachdruckverfahren sind die Lithographie und der Offsetdruck. Die strukturierte Platte kann z.B. als Druckplatte oder -walze verwendet werden. Das Druckmaterial kann zum Beispiel durch Sprühen, Tauchen, Rakeln, Streichen oder mittels Walzen aufgebracht werden. Mit dem erfindungsgemäßen Verfahren ist es möglich, über den Wechsel von Hydrophilie und Hydrophobie eine Übertragung von nahezu beliebigen flüssigen bis pastösen Komponenten zu erhalten.

Das Material zum Drucken weist flüssige bis pastöse Konsistenz auf. Es kann sich z.B. um wässrige Lösungen, Suspensionen oder Pasten handeln. Es können die üblichen Materialien, die zum Druck oder zur Übertragung in der Technik bekannt sind, verwendet werden. Es kann sich z.B. um metallhaltige Pasten, keramikhaltige Pasten und halbleiterhaltige Pasten oder entsprechende Suspensionen handeln. Werden die beladenen Oberflächen auf ein Empfangsmedium gedrückt, tritt dieses mit den auf der beladenen Oberfläche befindlichen Komponenten in Wechselwirkung, so dass ein Abbild der Struktur auf dem entsprechenden Empfangsmedium erzeugt werden kann. Das auf das Empfangsmedium übertragene Material kann getrocknet, gehärtet, verdichtet oder in anderer Weise weiterbehandelt werden.

Das Empfangsmedium kann z. B. ein solches sein, das zum Aufbau mikroelektronischer Schaltungen geeignet ist. Es kann sich z.B. um Kunststoff, z.B. eine Kunststofffolie, Metall, Papier, Glas oder eine keramische Oberfläche handeln. Natürlich sind die Eigenschaften des Empfangsmediums, z.B. bezüglich der Hydrophilie, mit denen des Materials zum Drucken abzustimmen.

Bei Einsatz der hydrophilen Bereiche können die freigelegten Bereiche zur Vermeidung von unerwünschten Reaktionen auch mit einer anderen hydrophilen Schicht als Schutzschicht überschichtet werden. Die Immobilisierung bzw. Deponierung des eigentlichen Materials zum Drucken kann dann auf dieser zweiten hydrophilen Schicht erfolgen.

Der besondere Vorteil des Gegenstands der Erfindung besteht in der Regenerierbarkeit der erfindungsgemäßen Platten, so dass bereits strukturierte Platten auch umstrukturiert werden können, d.h., die Strukturierung ist reversibel und die wertvolle Platte als solche ist wiederverwendbar. Dies ist z.B. nach Abnutzung, Beschädigung oder auch bei einer gewünschten Änderung des zu druckenden Musters jederzeit möglich.

Die Regenerierung wird z.B. in vorteilhafter Weise dadurch erreicht, dass nach Gebrauch die Oberfläche gegebenenfalls gereinigt wird, z.B. zur Entfernung von verbliebenem Druckmaterial, und dann die hydrophoben Bereiche der Oberflächenstruktur ganzflächig entfernt werden. Die so freigelegte, den hydrophilen Oxidationskatalysator enthaltende Schicht kann dann erneut mit einer hydrophoben Schicht beschichtet werden, so dass die regenerierbare Platte für eine neue Strukturierungsaufgabe verwendet werden kann.

Die ganzflächige Entfernung der hydrophoben Schicht ist dabei bevorzugt über zwei Verfahren möglich. Zum einen kann die Oberfläche flächenmäßig belichtet werden, um die hydrophoben Bereiche durch thermokatalytische Zersetzung von der Oberfläche vollständig zu entfernen. Dadurch kann die Platte ganz sauber von allen hydrophoben Bestandteilen oder eventuell vorhandenen UV-Absorptionsmitteln befreit werden, ohne dass irgendwelche Reste wie Pyrolyseprodukte zurückbleiben. Die regenerierte Platte kann daher ohne Einschränkung wiederverwendet werden.

Die ganzflächige Entfernung der hydrophoben Schicht kann auch durch Lösen mit einem Reinigungsmittel erfolgen. Als Reinigungsmittel eignet sich zum Beispiel irgendein organisches Lösungsmittel, in dem das Hydrophobiermittel löslich ist, z.B. ein unpolares Lösungsmittel, wie Hexan, Benzol oder Toluol, oder ein Tensid enthaltendes Spülmittel. Natürlich ist darauf zu achten, dass das Reinigungsmittel nicht die den hydrophilen Katalysator enthaltende Schicht angreift.

Alternativ kann die Regenerierung auch einfach dadurch erfolgen, dass man, gegebenenfalls nach Reinigung der Oberfläche, unmittelbar auf die strukturierte Oberfläche erneut Hydrophobiermittel aufbringt, um wieder eine ganzflächige hydrophobe Schicht zu erhalten, ohne dass die hydrophoben Bereiche der alten Strukturierung entfernt werden.

Nach der erneuten vollflächigen Hydrophobierung steht die so regenerierte Platte dann für eine Neustrukturierung mit einem anderen Bildmuster zur Verfügung. Auf diese Weise wird eine beliebig wiederholbare Wiederverwendung möglich.

Die Anwendung der Erfindung reicht allgemein von Druckprozessen in der Druckindustrie bis zu einer Transfertechnik, bei der bestimmte Informationen bzw. Strukturen der auf dem Substrat aufgezogenen Materialien übertragen werden. Eine weitere Anwendung ist der Aufbau von Strukturen, insbesondere Mikrostrukturen, wie Mikroreaktoren, Tüpfelplatten oder auch Reaktoren für die Kombinatorik, bei denen entsprechende hydrophile oder hydrophobe Bereiche entstehen. Eine weitere Anwendung besteht in der Erzeugung von sehr feinen Strukturen im Nano- oder Mikrometerbereich, bei denen die Hydrophilie oder die Hydrophobie zur Aufnahme von Zellen oder anderen biologischen Komponenten in gewünschten Anordnungen (Arrays) eingesetzt wird.

Neben der reinen Hydrophilierung an den belichteten Oberflächen ist es auch möglich, an den über die Belichtung freigelegten hydrophilen Bereichen, Reaktionen mit geeigneten Reagenzien durchzuführen, die zu einer chemischen Veränderung der Oberfläche führen (z.B. Einführung funktioneller Gruppen). So lassen sie z.B. durch die Ankopplung funktioneller Silane und deren Weiterreaktion fast jede beliebigen Oberflächenfunktionen erzeugen. So können z.B. Aminogruppen auf die belichteten Bereiche aufgezogen werden (Grafting), die gemäß den gängigen chemischen Reaktionen einmal funktionell weiterreagiert werden können (z.B. über Schiff'sche Base-Reaktionen oder Säurechloride) oder die auch zur Ankopplung von biologischen oder anderen Komponenten dienen können.

Bevorzugte Anwendungsmöglichkeiten dieser reversibel strukturierbaren Oberflächen sind Schichten mit auswählbaren hydrophob/hydrophilen Wechselwirkungen an der Oberfläche vom µm- bis zum nm-Bereich, z.B. für die Erzeugung antithrombogener Oberflächen, für die gezielte Immobilisierung bestimmter Zellen oder anderer biologischer Komponenten, insbesondere für die Immobilisierung von Enzymen, für Implantate, für die Herstellung reversibler, wiederbeschreibbarer Druckplatten und Druckwalzen (digital printing), insbesondere für Offset-Walzen, die Strukturierung von Stein für Steindruckverfahren und die Masterherstellung für die Mikrooptik und Sicherheitshologramme.

Das folgende Beispiel dient der weiteren Erläuterung der vorliegenden Erfindung.

### Beispiel

### 1. Herstellung Bindemittel

Zur Herstellung des Bindemittels wird eine Mischung aus 1069,9 g (6,0 mol) Methyltriethoxysilan und 312,5 g (1,5 mol) Tetraethoxysilan in zwei gleiche Portionen aufgeteilt. Zur ersten Portion gibt man unter Rühren 246,8 g Kieselsol (Levasil 300/30, Fa. Bayer). Nach Bildung einer Emulsion (ca. 30 s) gibt man 5,60 g 36 gew.-%ige HCl zu. Nach kurzem Rühren (30 bis 50 s) wird die Reaktionsmischung unter Erwärmen klar. Dazu gibt man die zweite Portion der vorher vorbereiteten Silanmischung in einem Zuge schnell zu. Nach kurzer Zeit trübt sich die Reaktionsmischung durch einen weißen Niederschlag (NaCl). Anschließend rührt man noch 15 min unter Kühlung in einem Eisbad nach. Man lässt das Silanhydrolysat zwölf Stunden bei Raumtemperatur stehen, dekantiert vom sedimentierten Feststoff ab und erhält so das lagerfähige Sol. Es wird vor Gebrauch durch Aktivierung mit Salzsäure (8% Massenanteil, Zugabe 0,108 g Säure pro g Sol) auf einen Hydrolysegrad von 0,8 eingestellt.

### 2. Herstellung Oxidationskatalysator und Beschichtungssuspension

Die katalytisch aktiven Materialien werden durch Imprägnierung von Aluminiumoxidpulvern mit Nitratlösungen hergestellt. 100 g Aluminiumoxid (Nabalox® NG100) werden mit einer Lösung von 22,97 g Mangannitrat, 27,27 g Kupfernitrat und 3,46 g Kaliumnitrat in 25 g Wasser imprägniert, im Trockenschrank getrocknet und bei 440°C für eine Stunde calciniert. Analog werden 50 g Aluminiumoxid (Martoxid® MR70) mit einer Lösung von 3,82 g Mangannitrat, 4,53 g Kupfernitrat und 0,57 g Kaliumnitrat in 10 g Wasser behandelt.

Die Beschichtungssuspension besteht aus 10,5 g NG 100, 4,50 g MR 70 (Einwaage bezogen auf imprägnierte Oxide) sowie 1,16 g eines schwarzen, anorganischen Pigments (als Imprägnierung auf den Oxiden), 8,25 g des vorstehend hergestellten Bindemittels und 0,89 g Salzsäure zur Aktivierung. Dazu werden 7,5 g 2-Butoxyethanol gegeben. Zur homogenen Durchmischung werden alle Komponenten (nach Aktivierung des Bindemittels) außer dem NG100-Pulver für 20 min unter Zusatz von Glasperlen in einem Schüttelmischer durchmischt und nach Zugabe des NG 100 weitere 5 Minuten geschüttelt.

### 3. Beschichtung des Substrats

Als Substrate wurden Edelstahl oder emaillierte Bleche (Pemco® 52092) verwendet. Die Vorreinigung erfolgte mit einer Isopropanol-KOH-Lösung im Ultraschallbad (15min), Spülen mit deionisiertem Wasser und Trocknen im Trockenschrank. Die vorstehend hergestellte, den Oxidationskatalysator enthaltene Suspension wird durch Sprühen aufgetragen und bei 80 bis 100°C im Trockenschrank 20 min angetrocknet. Anschließend wird die Schicht bei 440°C im Muffelofen 1 h ausgehärtet.

Auf das katalytisch beschichtete Substrat wurde eine Wachsschicht (Wachs von Aldrich, 34,689-6) durch Tauchbeschichten (115°C) mit einer Geschwindigkeit von 4,5 mm/s aufgebracht. Zur Einstellung der Wachsschichtdicke erfolgte eine nachträgliche Ofenbehandlung bei 140°C für 20 min.

### 4. Strukturierung durch Schreibverfahren

Das Lasersystem X2-600 der Fa. Universal Laser Systems ist ein CO₂-Laser und beinhaltet zwei verschiedene Betriebsmodi, mit denen Rasterbewegungen bzw. Vektorbewegungen möglich sind. Im Modus Rasterbewegung ist flächenmäßiges Gravieren möglich, bei welchem zeilenweise durch Vor- und Zurückbewegung strukturiert wird. Der Modus Vektorbewegung gestattet das Strukturieren von Konturen.

Die Laserintensität wird dadurch kontrolliert, dass der Lasersystemdruckertreiber jeder, bei der graphischen Zeichnung verwendeten Farbe eine bestimmte Intensität von 0 bis 100% zuweist, wobei 100% einer Laserleistung von 50 Watt entsprechen. Da der Laser proportional gepulst ist entspricht die prozentuale Intensität der Dauer der Laserimpulse (mit ∅ = 127 µm). Grundsätzlich wird die Intensitätseinstellung direkt auf die gewünschte Tiefe der Gravur bezogen. Aufgrund der linearen Intensitätseinstellung ist die Gravur bei einer Intensität von 100% zweimal so tief wie bei einer Intensität von 50%.

Die Wachsschicht des vorstehend hergestellten beschichteten Substrats wurde mit dem Lasersystem X2-600 mit einer Leistung von 5 W und einer Geschwindigkeit von 50 cm/s bestrahlt. Durch die Wärmeentwicklung während der Laserbestrahlung erfolgt die gewünschte Strukturierung.

### 5. Bewertung der erhaltenen Struktur

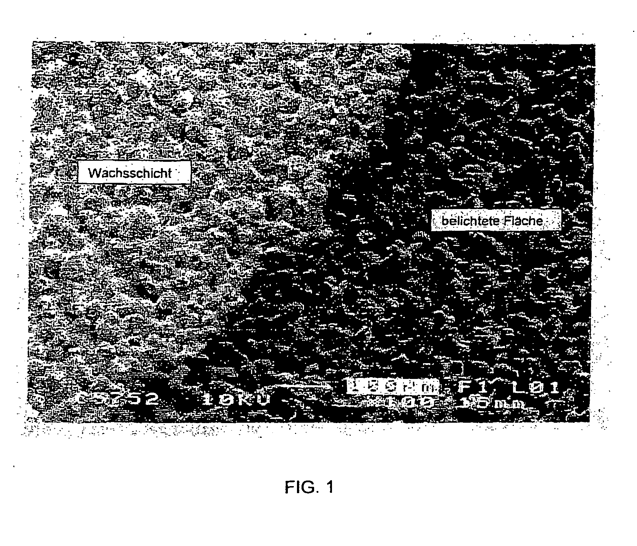

Figur 1 ist eine Aufnahme mit einem Rasterelektronenmikroskop, die eine Grenze zwischen Bereichen, die mit dem CO₂-Laser bestrahlt wurden, und unbestrahlten Bereichen zeigt. Sie zeigt, dass die Wachsschicht, die auf der katalytische aktiven, porösen Schicht aufgetragen wurde, im belichteten Bereich thermokatalytisch zersetzt worden ist.

Die Struktur wurde ferner anhand der Oberflächenenergie durch Kontaktwinkelmessung gegen H₂O bewertet. In einem Vorversuch wurde ein Kontaktwinkel gegen H₂O. für eine den Oxidationskatalysator enthaltende Schicht, auf die keine hydrophobe Schicht aufgebracht worden war, von <10° gemessen. Für das strukturierte Substrat ergab sich für die unbelichteten Bereiche ein Kontaktwinkel (H₂O) von 100° (Wachsschicht), während die belichteten Bereiche einen Kontaktwinkel (H₂O) von <10° aufwiesen.

Da die belichteten Bereiche gleiche Kontaktwinkel wie die den Katalysator enthaltende Schicht aufwiesen, die nicht mit einer hydrophoben Schicht behandelt wurde, folgt daraus, dass die Wachsschicht an den belichteten Bereichen durch lokale Erhitzung (CO₂-Laser-Bestrahlung) vollständig zersetzt wurde.

### 6. Beschichtung ohne katalytisch aktive Spezies

Wenn ein Substrat auf die gleiche Weise wie im vorstehend genannten Beispiel beschichtet wird, außer dass die Aluminiumoxide nicht mit den katalytisch aktiven Übergangsmetalloxiden imprägniert werden, kann durch die Laserbestrahlung keine Strukturierung erfolgen, da keine thermokatalytische Zersetzung der hydrophoben Schicht möglich ist.

## Patentansprüche

1. Verfahren zur Herstellung einer regenerierbaren Platte mit strukturierter Oberfläche aus hydrophilen und hydrophoben Bereichen, bei dem man die Oberfläche der regenerierbaren Platte, die ein Substrat und eine darüber liegende poröse Schicht mit einer spezifischen Oberfläche der Schicht von 20 m²/g bis 250 m²/g, bestimmt nach dem BET-Verfahren mit Stickstoff, aus einer Masse, die einen hydrophilen Oxidationskatalysator enthält, umfasst, mit einer hydrophoben Schicht beschichtet und bildmäßig belichtet, wobei Katalysator und Schicht in den belichteten Bereichen durch die Belichtung erwärmt werden, so dass die hydrophobe Schicht in den belichteten Bereichen unter Freilegung des darunter liegenden hydrophilen Oxidationskatalysators oxidativ zersetzt wird.

2. Verfahren zur Herstellung einer regenerierbaren Platte mit strukturierter Oberfläche nach Anspruch 1, **dadurch gekennzeichnet, dass** die hydrophobe Schicht ein UV-Absorptionsmittel umfasst und die Oberfläche mit UV-Licht und/oder VIS-Licht oder mittels Nahfeldoptik im UV- und/oder VIS-Bereich belichtet wird, wodurch die hydrophobe Schicht in den belichteten Bereichen erwärmt und unter Freilegung des darunter liegenden hydrophilen Oxidationskatalysators thermokatalytisch zersetzt wird.

3. Verfahren zur Herstellung einer regenerierbaren Platte mit strukturierter Oberfläche nach Anspruch 1, **dadurch gekennzeichnet, dass** mit IR-Licht belichtet wird.

4. Verfahren zur Herstellung einer regenerierbaren Platte mit strukturierter Oberfläche nach einem der Ansprüche 1 bis 3, **dadurch gekennzeichnet, dass** mit Laserlicht, insbesondere von einem UV-Laser oder einem CO₂-Laser, belichtet wird.

5. Verfahren zur Herstellung einer regenerierbaren Platte mit strukturierter Oberfläche nach einem der Ansprüche 1 bis 4, **dadurch gekennzeichnet, dass** für die bildmäßige Belichtung ein Maskenverfahren, ein holographisches Verfahren, ein nahfeldoptisches Verfahren (Nanolithographie) oder ein Laserschreibverfahren verwendet wird.

6. Verfahren zur Herstellung einer regenerierbaren Platte mit strukturierter Oberfläche nach einem der Ansprüche 1 bis 5, **dadurch gekennzeichnet, dass** man die Schicht mit dem hydrophilen Oxidationskatatysator durch Aufbringen eines Hydrophobiermittels hydrophobisiert, um die darüber liegende hydrophobe Schicht zu erhalten.

7. Verfahren zur Herstellung einer regenerierbaren Platte mit strukturierter Oberfläche nach einem der Ansprüche 1 bis 6, **dadurch gekennzeichnet, dass** man die freigelegte Schicht mit dem hydrophilen Oxidationskatalysator mit einer anderen Schicht als Schutzschicht überschichtet oder durch Reaktion mit einem Reagenz mit funktionellen Gruppen versieht, über die gegebenenfalls weitere Komponenten angekoppelt werden können.

8. Verfahren zur Herstellung einer regenerierbaren Platte mit strukturierter Oberfläche nach einem der Ansprüche 1 bis 7, **dadurch gekennzeichnet, dass** der hydrophile Oxidationskatalysator eine IR-absorbierende Schicht ist.

9. Verfahren zur Herstellung einer regenerierbaren Platte mit strukturierter Oberfläche nach einem der Ansprüche 1 bis 8, **dadurch gekennzeichnet, dass** die Masse, die den hydrophilen Oxidationskatalysator enthält, zusätzlich ein Bindemittel umfasst.

10. Verfahren zur Herstellung einer regenerierbaren Platte mit strukturierter Oberfläche nach Anspruch 9, **dadurch gekennzeichnet, dass** das Bindemittel ein Kondensat und/oder nanoskalige Teilchen umfasst, die jeweils vorzugsweise aus einem Tetraalkoxysilan und mindestens einem Silan, ausgewählt aus Alkyltrialkoxysilanen, Dialkoxysilanen, Aryltrialkoxysilanen und Diaryldialkoxysilanen gebildet werden.

11. Verfahren zur Herstellung einer regenerierbaren Platte mit strukturierter Oberfläche nach einem der Ansprüche 1 bis 10, **dadurch gekennzeichnet, dass** der Oxidationskatalysator als katalytisch aktive Komponente ein Übergangsmetalloxid oder eine Mischung von Übergangsmetalloxiden umfasst.

12. Verfahren zur Herstellung einer regenerierbaren Platte mit strukturierter Oberfläche nach einem der Ansprüche 1 bis 11, **dadurch gekennzeichnet, dass** die hydrophobe Schicht Paraffin, Wachs, Öl, Fett, Kohlenwasserstoffe, eine Seife und/oder eine Fettsäure, z.B. Stearinsäure oder Ölsäure, umfasst oder daraus besteht.

13. Verfahren zur Herstellung einer regenerierbaren Platte mit strukturierter Oberfläche nach einem der Ansprüche 1 bis 12, **dadurch gekennzeichnet, dass** die hydrophobe Schicht bei Erwärmung durch Belichtung im wesentlichen oxidativ zerstört wird.

14. Verfahren zur Herstellung einer regenerierbaren Platte mit strukturierter Oberfläche nach einem der Ansprüche 1 bis 13, **dadurch gekennzeichnet, dass** a) das Substrat mit einer Suspension, die den Oxidationskatalysator in Form von Teilchen und gegebenenfalls ein Bindemittel-Sol, das ein Kondensat und/oder nanoskalige Teilchen enthält, umfasst, beschichtet wird und b) die gebildete Schicht mit einem Hydrophobiermittel überzogen wird.

15. Regenerierbare Platte mit strukturierter Oberfläche aus hydrophilen und hydrophoben Bereichen, die eine regenerierbare Platte umfassend ein Substrat und eine poröse Schicht mit einer spezifischen Oberfläche der Schicht von 20 m²/g bis 250 m²/g, bestimmt nach dem BET-Verfahren mit Stickstoff, aus einer Masse, die einen hydrophilen Oxidationskatalysator enthält, und eine darüber liegende hydrophobe Schicht umfasst, wobei die hydrophobe Schicht bildmäßig auf der den hydrophilen Oxidationskatalysator enthaltenden Schicht angeordnet ist, so daß sich die strukturierte Oberfläche aus hydrophoben Bereichen und hydrophilen Bereichen ergibt.

16. Regenerierbare Platte mit strukturierter Oberfläche nach Anspruch 15, **dadurch gekennzeichnet, dass** die hydrophobe Schicht mindestens ein UV-Absorptionsmittel enthält.

17. Regenerierbare Platte mit strukturierter Oberfläche nach Anspruch 15 oder 16, erhältlich nach einem Verfahren der Ansprüche 1 bis 14.

18. Regenerierbare Platte mit strukturierter Oberfläche nach einem der Ansprüche 15 bis 17, **dadurch gekennzeichnet, dass** sie eine Druckplatte oder Druckwalze ist.

19. Verfahren nach Anspruch 1, **dadurch gekennzeichnet, dass** man zum Regenerieren der Platte von der strukturierten Oberfläche mit hydrophilen und hydrophoben Bereichen die hydrophoben Bereiche im wesentlichen ganzflächig entfernt und die freigelegte, den hydrophilen Oxidationskatalysator enthaltende Schicht erneut mit einer hydrophoben Schicht beschichtet, so dass die regenerierbare Platte wieder für eine Strukturierung mit einem neuen Bildmuster zur Verfügung steht.

20. Verfahren nach Anspruch 19, **dadurch gekennzeichnet, dass** man die hydrophoben Bereiche entfernt, indem man
a) die Oberfläche flächenmäßig belichtet, um die hydrophoben Bereiche durch thermokatalytische Zersetzung im wesentlichen vollständig zu entfernen, oder
b) die hydrophoben Bereiche der strukturierten Oberflächen mit einem Reinigungsmittel im wesentlichen vollständig entfernt.

21. Verfahren nach Anspruch 1, **dadurch gekennzeichnet, dass** man zum Regenerieren der Platte die strukturierte Oberfläche mit den hydrophilen und hydrophoben Bereiche so wie sie ist direkt mit einer zusätzlichen hydrophoben Schicht ganzflächig beschichtet, so dass die regenerierbare Platte erneut für eine Strukturierung mit einem neuen Bildmuster zur Verfügung steht.

22. Verfahren nach Anspruch 1, **dadurch gekennzeichnet, dass** man zum Drucken eines Materials mit flüssiger bis pastöser Konsistenz
a) das Material, das hydrophil oder hydrophob ist, auf eine regenerierbare Platte mit strukturierter Oberfläche aufbringt, wobei es sich entsprechend seiner hydrophilen oder hydrophoben Beschaffenheit auf die hydrophilen Bereiche oder die hydrophoben Bereiche verteilt,
b) die mit dem Material beladene regenerierbare Platte mit einem Empfangsmedium in Kontakt bringt und das Material bildmäßig auf das Empfangsmedium überträgt.

23. Verfahren nach Anspruch 22, **dadurch gekennzeichnet, dass** die Platte als Druckplatte oder Druckwalze verwendet wird.

24. Verwendung einer regenerierbaren Platte mit strukturierter Oberfläche nach Anspruch 15 zum Drucken, wie Offsetdruck, für die Mikroelektronik, für die Immobilisierung biologischer Komponenten, als antithrombogene Oberfläche oder für Implantate.

## Claims

1. A process for making a regeneratable plate having a structured surface comprising hydrophilic and hydrophobic regions, in which method the surface of the regeneratable plate, which comprises a substrate and an overlying porous layer that has a specific surface area of 20 m²/g to 250 m²/g as measured by the BET method (using nitrogen) and is made of a material containing a hydrophilic oxidation catalyst, is coated with a hydrophobic layer and exposed imagewise, catalyst and layer being heated in the exposed regions by exposure such that the hydrophobic layer is oxidatively decomposed in the exposed regions and the underlying hydrophilic oxidation catalyst is uncovered.

2. The process of claim 1 for making a surface-structured regeneratable plate, **characterised in that** the hydrophobic layer comprises a UV absorbent and the surface is exposed with UV light and/or VIS light or by means of near-field optics in the UV and/or VIS ranges, the hydrophobic layer thereby being heated in the exposed regions and decomposed thermocatalytically, uncovering the underlying hydrophilic oxidation catalyst.

3. The process of claim 1 for making a surface-structured regeneratable plate, **characterised in that** the plate is exposed to IR light.

4. The process according to one of the claims 1 to 3 for making a surface-structured regeneratable plate, **characterised in that** the plate is exposed to laser light, in particular to light from a UV laser or a CO₂ laser.

5. The process according to one of the claims 1 to 4 for making a surface-structured regeneratable plate, **characterised in that** a mask method, a holographic method, a near-field optical method (nanolithography) or a laser inscribing method is used for the imagewise exposure.

6. The process according to one of the claims 1 to 5 for making a surface-structured regeneratable plate, **characterised in that** the layer containing the hydrophilic oxidation catalyst is rendered hydrophobic by application of a water repellent in order to obtain the overlying hydrophobic layer.

7. The process according to one of claims 1 to 6 for making a surface-structured regeneratable plate, **characterised in that** the uncovered layer containing the hydrophilic oxidation catalyst is overcoated with another layer to protect it or is reacted with a
reagent to provide it with functional groups via which any further components may be coupled.

8. The process according to one of the claims 1 to 7 for making a surface-structured regeneratable plate, **characterised in that** the hydrophilic oxidation catalyst is an IR-absorbing layer.

9. The process according to one of the claims 1 to 8 for making a surface-structured regeneratable plate, **characterised in that** the material containing the hydrophilic oxidation catalyst also includes a binder.

10. the process of claim 9 for making a surface-structured regeneratable plate, **characterised in that** the binder comprises a condensate and/or nanoscale particles, each formed preferably from a tetraalkoxysilane and at least one silane selected from alkyltrialkoxysilanes, dialkoxysilanes, aryltrialkoxysilanes and diaryldialkoxysilanes.

11. The process according to one of the claims 1 to 10 for making a surface-structured regeneratable plate, **characterised in that**, as the catalytically active component, the oxidation catalyst comprises a transition-metal oxide or a mixture of transition-metal oxides.

12. The process according to one of the claims 1 to 11 for making a surface-structured regeneratable plate, **characterised in that** the hydrophobic layer comprises or consists of paraffin, wax, oil, fat, hydrocarbons, a soap and/or a fatty acid, e.g. stearic acid or oleic acid.

13. The process according to one of the claims 1 to 12 for making a surface-structured regeneratable plate, **characterised in that** the hydrophobic layer is substantially oxidatively destroyed on being heated by exposure.

14. The process according to one of the claims 1 to 13 for making a surface-structured regeneratable plate, **characterised in that** a) the substrate is coated with a suspension comprising the oxidation catalyst in the form of particles and, optionally, a binder sol containing a condensate and/or nanoscale particles, and b) the layer thus formed is covered with a water repellent.

15. A regeneratable plate having a structured surface comprising hydrophilic and hydrophobic regions, said regeneratable plate comprising a substrate and a porous layer that has a specific surface area of 20 m²/g to 250 m²/g as measured by the BET method (using nitrogen) and is made of a material containing a hydrophilic oxidation catalyst, and, thereon, a hydrophobic layer arranged imagewise on the layer containing the hydrophilic oxidation catalyst to thereby afford the structured surface comprising hydrophobic regions and hydrophilic regions.

16. The surface-structured regeneratable plate of claim 15, **characterised in that** the hydrophobic layer contains at least one UV absorbent.

17. The surface-structured regeneratable plate according to claim 15 or 16, obtainable via a process according to claims 1 to 14.

18. The surface-structured regeneratable plate according to one of the claims 15 to 17, **characterised in that** the plate is a printing plate or a printing roller.

19. The process of claim 1, **characterised in that** the plate is regenerated by removing the hydrophobic regions over substantially the entire structured surface having hydrophilic and hydrophobic regions, and recoating the uncovered layer containing the hydrophilic oxidation catalyst with a hydrophobic layer so as to make the regeneratable plate available once more for structuring with a new image pattern.

20. The process of claim 19, **characterised in that** the hydrophobic regions are removed by
a) exposing the entire surface so as to substantially completely remove the hydrophobic regions by thermocatalytic decomposition, or
b) using a cleaning agent to substantially completely remove the hydrophobic regions.

21. The process of claim 1, **characterised in that** the plate is regenerated by coating the entire structured surface thereof, as it is with its hydrophilic and hydrophobic regions, directly with an additional hydrophobic layer so as to make the plate available for structuring with a new image pattern.

22. The process of claim 1, **characterised in that**, for printing a material of liquid to pasty consistency,
a) the hydrophilic or hydrophobic material is applied to a surface-structured regeneratable plate, the material being distributed over the hydrophilic or the hydrophobic regions of the surface depending on whether said material is of hydrophilic or hydrophobic nature,
b) contacting the regeneratable plate with the material thereon with a receiving medium to thereby transfer the material imagewise to the receiving medium.

23. The process of claim 22, **characterised in that** the plate is used as a printing plate or a printing roller.

24. Use of a surface-structured regeneratable plate according to claim 15 for a printing process such as offset printing, in microelectronics, for immobilizing biological components, as an antithrombogenic surface or for implants.

## Revendications

1. Procédé pour fabriquer une plaque pouvant être régénérée et dotée d'une surface structurée comportant des zones hydrophiles et des zones hydrophobes, procédé dans lequel la surface de la plaque pouvant être régénérée est recouverte d'une couche hydrophobe et exposée photographiquement selon un motif, la plaque comportant un substrat et par-dessus une couche poreuse ayant une surface spécifique de couche comprise entre 20 m²/g et 250 m²/g, mesurée selon le procédé BET avec de l'azote, ladite couche étant obtenue à partir d'une masse contenant un catalyseur d'oxydation hydrophile, le catalyseur et la couche étant chauffés par la lumière dans les zones exposées photographiquement, de sorte que la couche hydrophobe est décomposée par oxydation dans les zones exposées photographiquement, mettant à nu le catalyseur d'oxydation hydrophile sous-jacent.

2. Procédé pour fabriquer une plaque pouvant être régénérée et dotée d'une surface structurée selon la revendication 1, **caractérisé en ce que** la couche hydrophobe comprend un produit absorbant les UV, et la surface est exposée à de la lumière UV et/ou de la lumière visible ou au moyen d'une optique de champ proche dans le domaine de l'UV ou du visible, la couche hydrophobe étant ainsi chauffée dans les zones exposées photographiquement et décomposée par thermocatalyse, mettant à nu le catalyseur d'oxydation hydrophile sous-jacent.

3. Procédé pour fabriquer une plaque pouvant être régénérée et dotée d'une surface structurée selon la revendication 1, **caractérisé en ce que** l'exposition photographique est réalisée avec de la lumière IR.

4. Procédé pour fabriquer une plaque pouvant être régénérée et dotée d'une surface structurée selon l'une des revendications 1 à 3, **caractérisé en ce que** l'exposition photographique est réalisée avec de la lumière laser, notamment provenant d'un laser UV ou d'un laser à CO₂.

5. Procédé pour fabriquer une plaque pouvant être régénérée et dotée d'une surface structurée selon l'une des revendications 1 à 4, **caractérisé en ce que** pour l'exposition photographique selon un motif souhaité, on utilise un procédé de masquage, un procédé holographique, un procédé d'optique de champ proche (nanolithographie) ou un procédé d'écriture laser.

6. Procédé pour fabriquer une plaque pouvant être régénérée et dotée d'une surface structurée selon l'une des revendications 1 à 5, **caractérisé en ce que** la couche avec le catalyseur d'oxydation hydrophile est rendue hydrophobe en appliquant un produit hydrophobe en vue de conserver la couche hydrophobe sous-jacente.

7. Procédé pour fabriquer une plaque pouvant être régénérée et dotée d'une surface structurée selon l'une des revendications 1 à 6, **caractérisé en ce que** la couche dégagée avec le catalyseur d'oxydation hydrophobe est recouverte par une autre couche servant de couche protectrice ou est munie par réaction avec un réactif de groupes fonctionnels sur lesquels d'autres composants peuvent être le cas échéant couplés.

8. Procédé pour fabriquer une plaque pouvant être régénérée et dotée d'une surface structurée selon l'une des revendications 1 à 7, **caractérisé en ce que** le catalyseur d'oxydation hydrophile est une couche absorbant les IR.

9. Procédé pour fabriquer une plaque pouvant être régénérée et dotée d'une surface structurée selon l'une des revendications 1 à 8, **caractérisé en ce que** la masse qui contient le catalyseur d'oxydation hydrophile comprend en plus un liant.

10. Procédé pour fabriquer une plaque pouvant être régénérée et dotée d'une surface structurée selon la revendication 9, **caractérisé en ce que** le liant comprend un condensat et/ou des particules aux dimensions nanométriques, lesquels sont de préférence formés à partir d'un tétraalkoxysilane et d'au moins un silane choisi parmi les aklyltrialkoxysilanes, les dialkocysilanes, les arytrialkocysilanes et les diaryldialkoxysilanes.

11. Procédé pour fabriquer une plaque pouvant être régénérée et dotée d'une surface structurée selon l'une des revendications 1 à 10, **caractérisé en ce que** le catalyseur d'oxydation comprend comme composants catalytiquement actifs un oxyde de métaux de transition ou un mélange d'oxydes de métaux de transition.

12. Procédé pour fabriquer une plaque pouvant être régénérée et dotée d'une surface structurée selon l'une des revendications 1 à 11, **caractérisé en ce que** la couche hydrophobe comprend ou est composée de paraffine, de cire, d'huile, de graisse, d'hydrocarbures, d'un savon et/ou d'un acide gras, par exemple d'acide stéarique ou d'acide oléique.

13. Procédé pour fabriquer une plaque pouvant être régénérée et dotée d'une surface structurée selon l'une des revendications 1 à 12, **caractérisé en ce que** la couche hydrophobe est détruite lors du chauffage par exposition essentiellement par voie oxydative.

14. Procédé pour fabriquer une plaque pouvant être régénérée et dotée d'une surface structurée selon l'une des revendications 1 à 13, **caractérisé en ce que** a) le substrat est recouvert avec une suspension qui comprend le catalyseur d'oxydation sous la forme de particules et le cas échéant d'un sol de liant qui contient un condensat et/ou des particules aux dimensions nanométriques, et b) la couche formée est revêtue d'un produit rendant hydrophobe.

15. Plaque pouvant être régénérée et dotée d'une surface structurée comportant des zones hydrophiles et des zones hydrophobes, laquelle comprend un substrat et une couche poreuse ayant une surface spécifique de couche comprise entre 20 m²/g et 250 m²/g, mesurée selon le procédé BET avec de l'azote, ladite couche étant obtenue à partir d'une masse contenant un catalyseur d'oxydation hydrophile, et une couche hydrophobe couchée dessus, la couche hydrophobe étant disposée sur la couche contenant le catalyseur d'oxydation hydrophile selon le motif souhaité, de sorte à obtenir la surface structurée comportant des zones hydrophiles et des zones hydrophobes.

16. Plaque pouvant être régénérée et dotée d'une surface structurée selon la revendication 15, **caractérisée en ce que** le couche hydrophobe contient au moins un produit absorbant les UV.

17. Plaque pouvant être régénérée et dotée d'une surface structurée selon la revendication 15 ou 6, obtenue par le procédé des revendications 1 à 14.

18. Plaque pouvant être régénérée et dotée d'une surface structurée selon l'une des revendications 15 à 17, **caractérisée en ce qu'**elle est une plaque d'impression ou un rouleau d'imprimerie.

19. Procédé selon la revendication 1, **caractérisé en ce que** pour régénérer la plaque, on enlève pratiquement la totalité de la surface des zones hydrophobes de la surface structurée composée de zones hydrophiles et de zone hydrophobes et la couche contenant le catalyseur d'oxydation hydrophile ainsi libérée est recouverte à nouveau d'une couche hydrophobe de sorte que la plaque pouvant être régénérée est prête à être restructurée avec un nouveau motif.

20. Procédé selon la revendication 19, **caractérisé en ce que** les zones hydrophobes sont enlevées
a) en exposant toute la surface en vue d'en enlever pratiquement la totalité des zones hydrophobes par décomposition thermocatalytique, ou
b) des zones hydrophobes de la surface structurée sont enlevées pratiquement entièrement avec un produit de nettoyage.

21. Procédé selon la revendication 1, **caractérisé en ce que** pour régénérer la plaque, on recouvre toute la surface structurée avec des zones hydrophiles et des zones hydrophobes, telle qu'elle est, directement avec une couche supplémentaire hydrophobe de sorte que la plaque pouvant être régénérée est prête à être restructurée avec un nouveau motif.

22. Procédé selon la revendication 1, **caractérisé en ce que** pour l'impression d'un matériau présentant une consistance liquide à pâteuse,
a) on applique le produit sur une plaque pouvant être régénérée et dotée d'une surface structurée, lequel produit est hydrophile ou hydrophobe, ledit produit se répartissant en fonction de ses propriétés hydrophiles ou hydrophobes sur les zones hydrophiles ou sur les zones hydrophobes,
b) on met en contact la plaque pouvant être régénérée chargée du matériau avec un support récepteur et on transpose le matériau sur le support récepteur selon le même motif.

23. Procédé selon la revendication 22, **caractérisé en ce que** la plaque est utilisée comme plaque d'impression ou comme rouleau d'imprimerie.

24. Utilisation d'une plaque pouvant être régénérée et dotée d'une surface structurée selon la revendication 15 pour une impression, telle qu'une impression Offset, pour la microélectronique, pour l'immobilisation de composants biologiques, comme surface antithrombogène ou pour des implants.
